# EUROPEAN PATENT APPLICATION

(11) **EP 4 793 555 A1**
(43) Date of publication of application: **19.08.2026**
(21) Application number: 26158015.3
(22) Date of filing: 12.02.2026
(51) Int. Cl.: F24C 15/10, F24C 15/20, F24C 15/00, H05B 6/12

(54) **COOKING APPLIANCE**

(30) Priority: 14.02.2025 KR 20250019608; 09.12.2025 KR 20250194060
(71) Applicant: LG Electronics Inc., Yeongdeungpo-gu Seoul 07336 (KR)
(72) Inventor: LEE, Dongheon, Seoul (KR); KIM, Wontae, Seoul (KR); LEE, Seung Ho, Seoul (KR); LEE, Ji Won, Seoul (KR); SEO, Kyejin, Seoul (KR); JIN, Deokkyung, Seoul (KR)
(74) Representative: Vossius & Partner Patentanwälte Rechtsanwälte mbB

(57) **Abstract**

An invention relating to a cooking appliance is disclosed. The disclosed invention comprises: an electric component housing part accommodating a plurality of circuit parts, and a cooling fan introducing air into an internal space of the electric component housing part through an intake port and discharging the air to an outside through an exhaust port, wherein each of the circuit parts is one of a first circuit part and a second circuit part forming different circuits, the first circuit part includes a heat dissipation member on which a heat-generating component is installed, and the heat dissipation member is disposed in an air flow path connecting the intake port and the discharge port.

## Description

### TECHNICAL FIELD

The present disclosure relates to a cooking appliance, and more particularly, to a cooking appliance providing a function of sucking and removing contaminants generated during a cooking process.

### BACKGROUND

In general, a cooktop is a heating appliance installed on a countertop and providing a space in which food is cooked by a user. The cooktop includes a top plate disposed on the countertop, and the top plate forms a flat support surface to stably support a heating target such as a pot, a frying pan, and the like.

Below the top plate, a heating unit for actually heating the heating target is disposed. The heating unit may include a heating element such as an electric heater or an induction coil, and directly provides heat to the heating target through heat or an electromagnetic field transmitted through the top plate. The heating unit may be configured with a plurality of regions such as two regions, three regions, or four regions according to cooking performance, and each region is designed to be independently controllable.

The cooktop typically includes an operation panel for control of the heating unit, and a user may select or adjust heating intensity, a timer, a lock function, and the like through the operation panel. The operation panel may be integrally formed on an upper surface of the top plate, or may be separately provided on a side surface or a lower portion. Each heating unit is electrically connected to electric components for controlling a corresponding circuit, and typically, the electric components are collectively disposed in a lower space of the cooking appliance.

Recently, as various functions such as cooking control, safety detection, a display, and the like are integrated into the cooktop itself, a multifunctional cooking appliance exceeding a simple heating function has appeared. Accordingly, electric components for performing various functions are mounted together inside the cooking appliance.

In particular, when a hood function is combined with the cooktop, not only components such as a suction fan, a filter, a flow path, and the like, but also electric components for controlling the same must be disposed together inside, and thus, securing a space for the electric components is becoming more difficult. Accordingly, efficiently arranging a plurality of electric components in a limited internal space is becoming an important issue.

### SUMMARY

### Technical Problems

An object of the present disclosure is to provide an air flow structure for improving cooling efficiency of an electric component part.

Another object of the present disclosure is to provide a structure capable of efficiently controlling heat generation within the electric component part.

Still another object of the present disclosure is to provide a structure for securing stability and reliability of a product by minimizing thermal influence around the electric component part.

### Technical Solutions

A cooking appliance according to one embodiment of the present disclosure for achieving the above objects includes an electric component housing part accommodating a plurality of circuit parts, and a cooling fan allowing air to flow into an internal space of the electric component housing part through an intake port and to be discharged to the outside through an exhaust port, wherein each circuit part is one of a first circuit part and a second circuit part forming different circuits, the first circuit part includes a heat dissipation member having a heat-generating component installed thereon, and the heat dissipation member is disposed in an air flow path connecting the intake port and a discharge port.

Another embodiment of the present disclosure is characterized in that the intake port is formed in a lower portion of the electric component housing part and the exhaust port is formed in a front surface, and the cooling fan allows air introduced through the intake port to flow forward toward the heat dissipation member.

Still another embodiment of the present disclosure is characterized in that a top plate is disposed above the electric component part, an operation panel is disposed at a front portion of the top plate, an exhaust port of the electric component part is formed in a front surface of the electric component part, and a louver for guiding exhaust flow downward so as not to be directed toward the operation panel is provided in the electric component part.

A cooking appliance according to one aspect of the present disclosure includes a top plate covering a component arrangement space and an electric component part disposed in the component arrangement space, wherein the electric component part includes a plurality of circuit parts; an electric component housing part accommodating the circuit parts and having an intake port and an exhaust port; and a cooling fan allowing air to flow into an internal space of the electric component housing part through the intake port and to be discharged to the outside through the exhaust port.

Each circuit part is one of a first circuit part and a second circuit part forming different circuits, the first circuit part includes a heat dissipation member having a heat-generating component installed thereon, and the heat dissipation member may be disposed in an air flow path connecting the intake port and the discharge port.

The intake port is disposed below the cooling fan, and preferably forms a vertical passage opening an internal space of the electric component housing part to an outside of the electric component housing part.

The exhaust port preferably forms a horizontal passage opening the internal space of the electric component housing part to the outside of the electric component housing part.

The intake port is disposed below the cooling fan, and preferably forms a vertical passage in a vertical direction opening the internal space of the electric component housing part to the outside of the electric component housing part.

The cooling fan is preferably a centrifugal fan sucking air in a vertical direction and discharging the sucked air in a horizontal direction.

The second circuit part preferably includes a filter circuit part for processing power supplied to the first circuit part.

The filter circuit part is preferably disposed at a position located outside the air flow path or at a position deviating from the air flow path connecting the intake port and the exhaust port.

In a horizontal direction, the heat dissipation member is preferably disposed between the cooling fan and the exhaust port, and the cooling fan is preferably disposed between the filter circuit part and the exhaust port.

The present disclosure may further include a heating unit for heating a heating target disposed on the top plate.

The first circuit part may include an inverter circuit part provided for driving the heating unit and electrically connected to the filter circuit part.

The electric component housing part may further include an electric component supporter supporting at least one of the plurality of circuit parts.

The first circuit part and the cooling fan are preferably installed on the electric component supporter.

The electric component supporter may include a partition part partitioning the internal space of the electric component housing part into a plurality of electric component spaces.

The first circuit part and the cooling fan are preferably disposed together in one of the plurality of electric component spaces.

At least one of the plurality of electric component spaces may include a first divided space part and a second divided space part divided in a horizontal direction.

The first divided space part is preferably disposed with the first circuit part, and the second divided space part is preferably disposed with the second circuit part.

In the horizontal direction, the first divided space part is preferably disposed between the second divided space part and the exhaust port, and the cooling fan is preferably disposed between the first circuit part and the second circuit part.

The electric component supporter includes a partition part supporting the first circuit part and the cooling fan from below, and the partition part is preferably provided with an internal intake port forming a passage opening the cooling fan toward a lower side of the partition part.

The cooling fan may include an intake port opened toward the internal intake port and a discharge port opened toward the exhaust port.

The internal intake port is preferably formed in a shape corresponding to an outer shape of the intake port.

The electric component housing part may further include an electric component supporter supporting at least one of the circuit part and the cooling fan, and an electric component case accommodating the electric component supporter.

At least one of the intake port and the exhaust port is preferably formed in the electric component case.

The electric component case may include a bottom part forming a lower surface of the electric component case, and a side wall part disposed on a horizontally outer side of the electric component supporter and forming a front surface and a side surface of the electric component case.

The exhaust port is preferably disposed in the side wall part.

The exhaust port is preferably disposed in each of the front surface and the side surface of the electric component case.

The electric component part may further include a louver disposed in the side wall part and blocking between the top plate and the exhaust port.

The present disclosure may further include an operation panel connected to at least one of the plurality of circuit parts, and
in a vertical direction, the operation panel is preferably disposed between the exhaust port and the top plate, and the louver is preferably disposed between the exhaust port and the operation panel.

The louver may include an upper cover part covering above the exhaust port; a front cover part spaced apart from the exhaust port and covering a front side; and an opening part opening downward a flow path formed between the front cover part and the exhaust port.

The intake port is preferably formed in a lower surface of the electric component case.

The electric component part may further include a cover case covering at least a portion of the intake port and installed on a lower surface of the electric component case.

An internal space of the cover case communicates with the intake port, and the cover case is preferably formed with a side intake port opening the internal space of the cover case in a lateral direction.

A plurality of cooling fans are preferably arranged in different electric component spaces, and a plurality of exhaust ports are preferably disposed in a vertical direction.

### Advantageous Effects

The present disclosure forms a cold air flow path in which outside air is sucked from below and discharged forward, and through this, shortens a cold air flow path of the electric component part and reduces flow path resistance, thereby improving cooling efficiency of the inverter circuit part and the heat dissipation member.

The present disclosure, by independently arranging a plurality of cooling fans in the electric component spaces, may independently cool heat generated from circuit parts of each electric component space, thereby improving overall cooling performance of the electric component part.

In addition, the present disclosure, by arranging a louver above the exhaust port to guide a flow of discharged air downward, may block heat transmission toward the operation panel side and suppress a temperature rise of the operation panel, thereby increasing safety and reliability of a product.

### BRIEF DESCRIPTION OF DRAWINGS

The accompanying drawings constitute a part of the specification, illustrate one or more embodiments in the disclosure, and together with the specification, explain the disclosure, wherein:
FIG. 1 is a view illustrating an installation state of a cooking appliance according to one embodiment of the present disclosure;
FIG. 2 is a front perspective view illustrating the cooking appliance shown in FIG. 1 in a disassembled state;
FIG. 3 is a rear perspective view of the cooking appliance shown in FIG. 2;
FIG. 4 is a view showing a state in which a top plate is removed from the cooking appliance shown in FIG. 2;
FIG. 5 is a plan cross-sectional view illustrating the internal structure of the cooking appliance shown in FIG. 2;
FIG. 6 is a side cross-sectional view illustrating the internal structure of the cooking appliance shown in FIG. 2;
FIGS. 7 and 8 are front cross-sectional views showing the internal structure of the cooking appliance shown in FIG. 2;
FIG. 9 is a perspective view illustrating an exhaust device in a disassembled state;
FIG. 10 is a perspective view illustrating an upper open state of the exhaust device shown in FIG. 9;
FIG. 11 is an exploded perspective view illustrating a disassembled state of the exhaust device shown in FIG. 9;
FIG. 12 is a side cross-sectional view showing an internal structure of the exhaust device shown in FIG. 9;
FIG. 13 is a view illustrating a state in which a filter is separated from the exhaust device;
FIG. 14 is an exploded perspective view illustrating a disassembled state of a hood housing and a filter;
FIG. 15 is a front cross-sectional view showing an internal structure of a fluid collection part according to one embodiment of the present disclosure;
FIG. 16 is a front cross-sectional view showing a component arrangement state in a component arrangement space;
FIG. 17 is a block diagram showing a configuration of the cooking appliance according to one embodiment of the present disclosure;
FIG. 18 is a perspective view illustrating the electric component part in a disassembled state in the cooking appliance according to one embodiment of the present disclosure;
FIG. 19 is a view showing a state in which an electric component case is removed from the electric component part shown in FIG. 18;
FIG. 20 is a side cross-sectional view showing an internal structure of the electric component part shown in FIG. 18;
FIG. 21 is a plan cross-sectional view showing an arrangement state of a circuit part in a first electric component space;
FIG. 22 is a bottom view showing an arrangement state of a circuit part in a second electric component space;
FIG. 23 is a plan view showing an arrangement state of a circuit part in a third electric component space;
FIG. 24 is a plan view showing an arrangement state of a circuit part in a fourth electric component space;
FIG. 25 is a perspective view showing a spaced structure of a first circuit part and a second circuit part on an electric component supporter;
FIG. 26 is a perspective view showing a vertical direction spaced structure of each circuit part on the electric component supporter;
FIG. 27 is a side cross-sectional view showing the vertical direction spaced structure of each circuit part on the electric component supporter;
FIG. 28 is a view showing a shape of a protruding structure formed on a bottom surface of the electric component supporter;
FIG. 29 is a view showing a shape of a protruding structure formed on a lower surface of the electric component supporter;
FIG. 30 is an enlarged view illustrating the protruding structure shown in FIG. 29;
FIG. 31 is a side cross-sectional view showing an arrangement structure of a direct current circuit part and an alternating current circuit part;
FIG. 32 is a bottom perspective view showing an arrangement state of a circuit part in a direct current side electric component space;
FIG. 33 is a bottom view showing an arrangement state of a circuit part in a direct current side electric component space;
FIG. 34 is a plan view showing an arrangement state of a circuit part in an alternating current side electric component space;
FIG. 35 is an enlarged view illustrating a through hole shown in FIG. 34;
FIG. 36 is a bottom perspective view illustrating an electric component part in a disassembled state according to one embodiment of the present disclosure;
FIG. 37 is a bottom view of the electric component part shown in FIG. 36;
FIG. 38 is a view showing a state in which an external housing is removed from the electric component part shown in FIG. 37;
FIG. 39 is a view showing a state in which an electric component case is removed from the electric component part shown in FIG. 36;
FIG. 40 is a perspective view showing a cold air flow in an electric component space;
FIG. 41 is a front view of the electric component part shown in FIG. 36;
FIG. 42 is a view showing a state in which an electric component case is removed from the electric component part shown in FIG. 41;
FIG. 43 is a front cross-sectional view showing an internal structure of the electric component part shown in FIG. 42;
FIG. 44 is a side view showing a cold air flow in an electric component space;
FIG. 45 is a side cross-sectional view showing a cold air flow in a third electric component space;
FIG. 46 is a side cross-sectional view showing a cold air flow in a fourth electric component space;
FIG. 47 is a view showing a cold air exhaust flow in an electric component part;
FIG. 48 is a side cross-sectional view showing a structure of an exhaust port and a louver;
FIG. 49 is a perspective view showing an installation state of a communication module according to one embodiment of the present disclosure;
FIG. 50 is a plan view of the electric component part shown in FIG. 49;
FIG. 51 is a front view of the electric component part shown in FIG. 49;
FIG. 52 is a view showing a state in which an electric component case is covered on an electric component supporter shown in FIG. 51;
FIG. 53 is a perspective view showing a combined state of a heating unit case and the electric component part;
FIG. 54 is an enlarged view illustrating a portion "54" of FIG. 53;
FIGS. 55 and 56 are side cross-sectional views showing a process in which a hooking protrusion is coupled to the heating unit case;
FIG. 57 is a side cross-sectional view showing a state in which the hooking protrusion is coupled to the heating unit case;
FIG. 58 is a bottom view illustrating a lower surface of the electric component supporter; and
FIG. 59 is a view showing a state in which an electric component case is coupled to the electric component supporter shown in FIG. 58.

### DETAILED DESCRIPTION

The above-described aspects, features and advantages are specifically described hereafter with reference to accompanying drawings such that one having ordinary skill in the art to which the disclosure pertains can embody the technical spirit of the disclosure easily. In the *disclosure, detailed description* of known technologies in relation to the subject matter of the disclosure *is* omitted if it is deemed to *make* the *gist* of the *disclosure* unnecessarily *vague* Hereafter, preferred embodiments according to the disclosure are specifically described with reference to the accompanying drawings. In the drawings, identical reference numerals can denote identical or similar components.

The terms "first", "second" and the like are used herein only to distinguish one component from another component. Thus, the components are not to be limited by the terms. Certainly, a first component can be a second component, unless stated to the contrary.

Embodiments are not limited to the embodiments set forth herein, and can be modified and changed in various different forms. The embodiments in the disclosure are provided such that the disclosure can be through and complete and fully convey its scope to one having ordinary skill in the art. Accordingly, *all modifications, equivalents or replacements as well as a replacement of the configuration of any one embodiment with the configuration of another embodiment or an addition of the configuration of any one embodiment to the configuration of another embodiment, within* the technical spirit and scope of the disclosure, *are to be included in* the scope of the disclosure.

The accompanying drawings are provided for a better understanding of the embodiments set forth herein and are not intended to limit the technical spirit of the disclosure. It is to be understood that *all the modifications, equivalents or replacements within* the spirit and technical scope of the disclosure *are included in* the scope of the disclosure. The sizes or thicknesses of the components in the drawings are exaggerated or reduced to ensure ease of understanding and the like. However, the protection scope of the subject matter of the disclosure is not to be interpreted in a limited way.

The terms in the disclosure are used only to describe specific embodiments or examples and not intended to limit the subject matter of the disclosure. In the disclosure, singular forms include plural forms as well, unless explicitly indicated otherwise. In the disclosure, the terms "comprise", "comprised of" and the like specify the presence of stated features, integers, steps, operations, elements, components or combinations thereof but do not imply the exclusion of the presence or addition of one or more other features, integers, steps, operations, elements, components or combinations thereof.

The terms "first", "second" and the like are used herein only to distinguish one component from another component, and the components are not to be limited by the terms.

When any one component is described as "connected" or "coupled" to another component, any one component can be directly connected or coupled to another component, but an additional component can be "interposed" between the two components or the two components can be "connected" or "coupled" by an additional component. When any one component is described as "directly connected" or "directly coupled" to another component, an additional component cannot be "interposed" between the two components or the two components cannot be "connected" or "coupled" by an additional component.

When any one component is described as being "on (or under)" another component, any one component can be directly on (or under) another component, and an additional component can be interposed between the two components.

Unless otherwise defined, all the terms including technical or scientific terms used herein have the same meaning as commonly understood by one having ordinary skill in the art. Additionally, terms such as those defined in commonly used dictionaries are to be interpreted as having a meaning that is consistent with their meaning in the context of the relevant art, and unless explicitly defined herein, are not to be interpreted in an ideal way or an overly formal way.

In the state where a cooking appliance stands on the floor, a direction in which a door is installed with respect to the center of the cooking appliance is defined as a forward direction. Accordingly, a direction toward the inside of the cooking appliance with the door open is defined as a rearward direction. For convenience, the forward direction and the rearward direction can be referred to as a first direction. Then the forward direction is referred to as one direction of the first direction, and the rearward direction is referred to as the other direction of the first direction.

Additionally, a gravitational direction can be defined as a downward direction, and a direction opposite to the gravitational direction can be defined as an upward direction.

Further, a horizontal direction across a front-rear direction of the cooking appliance, i.e., a widthwise direction of the cooking appliance that is seen in front of the door of the cooking appliance, can be referred to as a left-right direction. For convenience, the left-right direction can be referred to as a second direction. Then the right side can be referred to as one direction of the second direction, and the left side can be referred to as the other direction of the second direction.

Further, the widthwise direction of the cooking appliance can also be referred to as a lateral direction. Then the right side can also be referred to as one side of the lateral direction, and the left side can be referred to the other side of the lateral direction.

Additionally, a vertical direction can be referred to as a third direction. Then an upward direction can be referred to as one direction of the third direction, and a downward direction can be referred to as the other direction of the third direction.

Furthermore, the vertical direction can be referred to as a vertical direction. Then the front-rear direction and the left-right direction, i.e., the first direction and the second direction, can be referred to as the horizontal direction.

Throughout the disclosure, the terms "A and/or B" as used herein can denote A, B or A and B, and the terms "C to D" can denote C or greater and D or less, unless stated to the contrary.

### [Entire structure of cooking appliance]

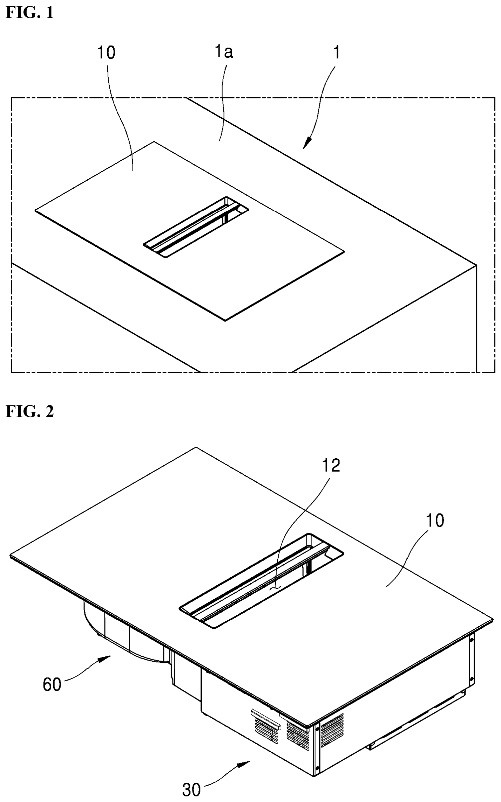

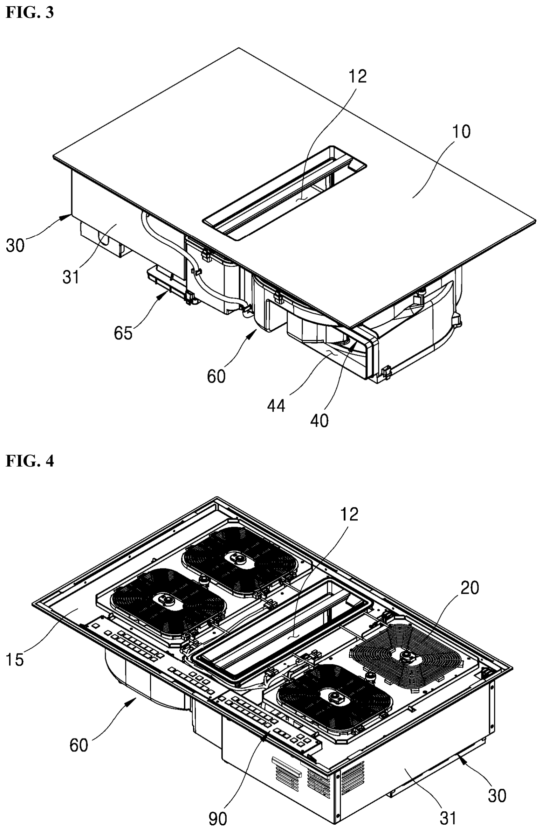

FIG. 1 is a view showing an installation state of a cooking appliance according to one embodiment of the present disclosure, and FIG. 2 is a front perspective view illustrating the cooking appliance shown in FIG. 1 in a disassembled state. FIG. 3 is a rear perspective view illustrating the cooking appliance shown in FIG. 2 in a disassembled state, and FIG. 4 is a view showing a state in which a top plate is removed from the cooking appliance shown in FIG. 2.

Referring to FIGS. 1 to 4, the cooking appliance according to one embodiment of the present disclosure may include a heating device and an exhaust device.

The heating device may be disposed on an upper portion of the cooking appliance. In the present embodiment, a heating device in a form of an electric range is exemplified. The cooking appliance exemplified herein is a concept including both an electric range of an electric resistance type and an electric range of an induction heating type. For convenience of description, an embodiment of the present disclosure will be described focusing on an electric range including a working coil as a heating unit. However, the present disclosure is not limited thereto.

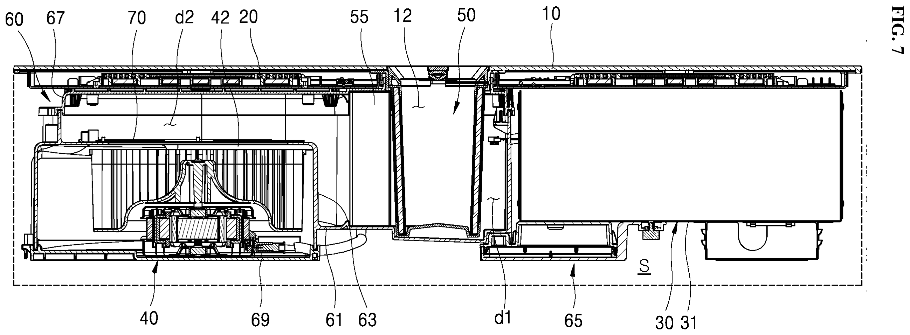

As an example, the heating device may include a top plate 10. The top plate 10 is disposed above the heating device and may form an outer appearance of an upper surface of the heating device and the cooking appliance. The top plate 10 is provided to cover above a component arrangement space S (see FIG. 7).

The component arrangement space S is a space disposed vertically below the top plate 10 and is an area in which internal components of the cooking appliance are disposed. Conceptually, the component arrangement space S may be defined as an internal area surrounded by imaginary vertical walls obtained by vertically extending a horizontal outer edge line of the top plate 10.

In other words, the component arrangement space S may be in an open state in which an upper side is covered by the top plate 10 and side portions and a lower portion are not structurally completely surrounded by walls. Accordingly, the component arrangement space S is not a closed chamber but is an abstract space concept in which components are functionally disposed inside the cooking appliance.

The top plate 10 is located at an uppermost portion of the cooking appliance and may be formed in a flat plate shape. The top plate 10 may provide a seating surface on which a container containing food and the like (hereinafter, referred to as a "heating target") may be seated. As an example, the top plate 10 may be formed of ceramic glass and may be formed in a rectangular flat plate shape having a thickness.

The cooking appliance may be disposed with at least one heating unit 20. For example, a plurality of heating units 20 may be arranged in a horizontal direction in the cooking appliance. Each heating unit 20 may be disposed on the top plate, or may be disposed around the top plate, such as above or below the top plate.

As an example, each heating unit 20 may include a working coil disposed below the top plate 10. As another example, the heating unit 20 may include a burner burning gas, or may be provided in a form including a hot plate or a highlight generating heat by heating a metal plate or a ceramic plate with a heating wire. As still another example, the cooking appliance may include two or more of a working coil, a burner, a hot plate, and a highlight.

The heating device may further include a heating unit case 15. The heating unit case 15 may be formed in a polygonal shape having an open upper portion. The open upper portion of the heating unit case 15 is covered by the top plate 10, and various components constituting the heating device may be accommodated inside the heating unit case 15. In the present embodiment, a form in which components constituting the heating unit 20, for example, a working coil, are accommodated inside the heating unit case 15 is exemplified.

As an example, the heating unit case 15 may be formed in a rectangular box shape made of aluminum, however, the shape and material of the heating unit case 15 are not limited thereto. The heating unit case 15 may be thermally insulated to suppress an increase in temperature of an outer surface of the heating unit case 15 due to heat generated by the working coil.

The heating device may further include an electric component part 30. The electric component part 30 may include electric components related to driving of the heating device, particularly the heating unit 20. In the present embodiment, the electric component part 30 is exemplified as being disposed below the top plate 10, more specifically, below the heating unit case 15.

The electric component part 30 may include an electric component case 32. According to the present embodiment, the electric component case 32 may be formed in a polygonal shape having an open upper portion. The open upper portion of the electric component case 32 is covered by the heating unit case 15 or the top plate 10, and various electric components may be accommodated inside the electric component case 32.

As an example, at least one of the heating unit case 15 and the electric component case 32 may be formed in a rectangular box shape made of aluminum, however, the shapes and materials of the heating unit case 15 and the electric component case 32 are not limited thereto. At least one of the heating unit case 15 and the electric component case 32 may be thermally insulated to suppress an increase in temperature of an outer surface of the electric component case 32 due to heat generated by the working coil or the electric components.

The cooking appliance including the heating device may be installed on a support 1. The support 1 is a structure for installing or fixing components of the cooking appliance and may be provided in a predetermined cabinet structure. An internal space capable of accommodating at least a portion of the heating device and the exhaust device may be formed inside the support 1.

As an example, the support 1 may be provided in a form of kitchen furniture, more specifically, a lower cabinet. An upper portion of the support 1 provided in the form of kitchen furniture may be provided with a countertop 11. The heating device and the exhaust device may be installed on the countertop 11.

According to the present embodiment, only a portion of the heating device is exposed above the countertop 11, and the remaining portion may be inserted into the support 1 to be disposed below the countertop 11. For example, the top plate 10 may be exposed above the countertop 11, and the heating unit 20 may be disposed below the countertop 11.

As another example, the support 1 may be provided in a form of a cooking appliance including an oven. In this case, the heating device and the exhaust device installed on an upper surface of the support 1 may be disposed above a cooking chamber of the oven.

An opening 12 may be provided in the top plate 10. The opening 12 may form a passage for opening the component arrangement space S toward an upper side of the top plate 10 in the top plate 10. The opening 12 may be formed in a hole shape penetrating the top plate 10 in a vertical direction.

The exhaust device may be disposed adjacent to the heating device. More specifically, the exhaust device may be disposed in a space below the top plate 10, that is, in the component arrangement space S. The exhaust device is provided to collect smoke, steam, contaminants, and the like generated around the exhaust device (hereinafter, collectively referred to as "contaminated air").

Contaminated air generated from a heating target seated on the top plate 10 may be collected into an inside of the exhaust device through the opening 12. The contaminated air collected into the exhaust device may be transmitted into the support 1 through an inside of the exhaust device.

### [Entire structure of exhaust device]

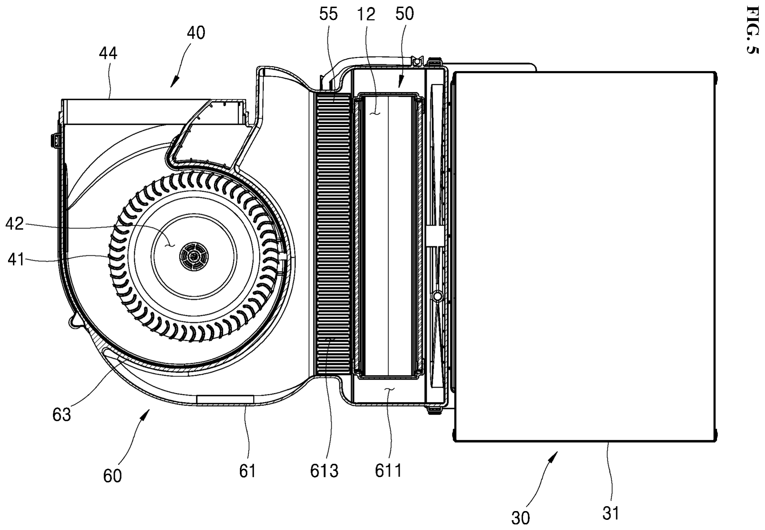

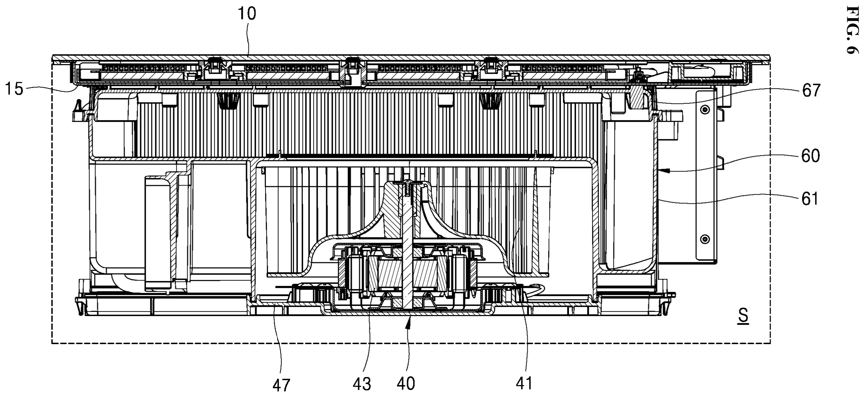

FIG. 5 is a plan cross-sectional view showing an internal structure of the cooking appliance shown in FIG. 2, FIG. 6 is a side cross-sectional view showing the internal structure of the cooking appliance shown in FIG. 2, and FIGS. 7 and 8 are front cross-sectional views showing the internal structure of the cooking appliance shown in FIG. 2.

Referring to FIGS. 5 to 8, the exhaust device may include a fan 40. At least a portion of the fan 40 may be disposed in the component arrangement space S. The fan 40 may suck air above the top plate 10 through an opening 12. For example, the fan 40 disposed below the top plate 10 may suck contaminated air generated from the heating target seated on the top plate 10 through the opening 12.

An air flow path d1, d2 for air flow may be formed between the opening 12 and the fan 40. Air introduced into the component arrangement space S through the opening 12 may flow toward the fan 40 through the air flow path d1, d2. For example, the opening 12 and the intake port 42 may be connected by the air flow path d1, d2, and contaminated air outside the cooking appliance may be introduced into the air flow path d1, d2 through the opening 12 and then may flow toward the fan 40 through the air flow path d1, d2.

The exhaust device may further include at least one filter 50, 55. The filter 50, 55 may be disposed in the component arrangement space S and may be disposed between the opening 12 and the fan 40.

According to the present embodiment, at least a portion of the filter 50, 55 may be disposed in the air flow path d1, d2. For example, at least a portion of the filter 50, 55 may be disposed between the opening 12 and the fan 40 in a horizontal direction.

The filter 50, 55 may filter contaminated air introduced into the air flow path d1, d2 through the opening 12. Air introduced into the air flow path d1, d2 through the opening 12 may pass through the filter 50, 55 and be filtered by the filter 50, 55, and then may flow toward the fan 40.

The exhaust device may further include a hood housing 60. The hood housing 60 is disposed in the component arrangement space S and is provided to accommodate at least a portion of the fan 40 and at least a portion of the filter 50, 55.

An air flow path d1, d2 may be formed inside the hood housing 60. Contaminated air outside the cooking appliance may be introduced into the hood housing 60 through the opening 12 and may flow toward the fan 40 through the air flow path d1, d2 formed inside the hood housing 60.

### [Fan]

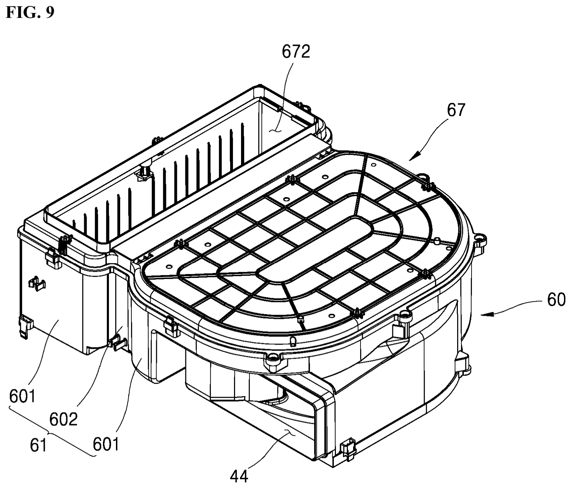

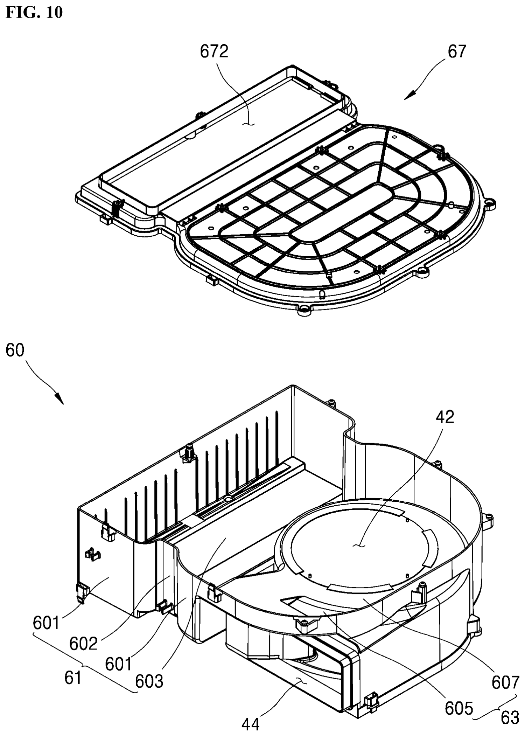

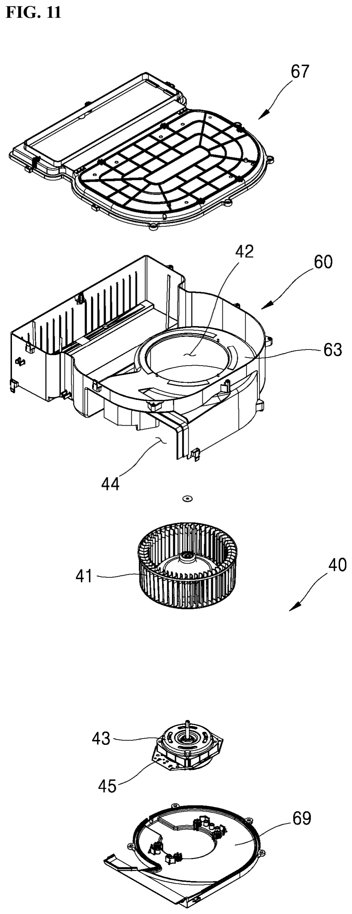

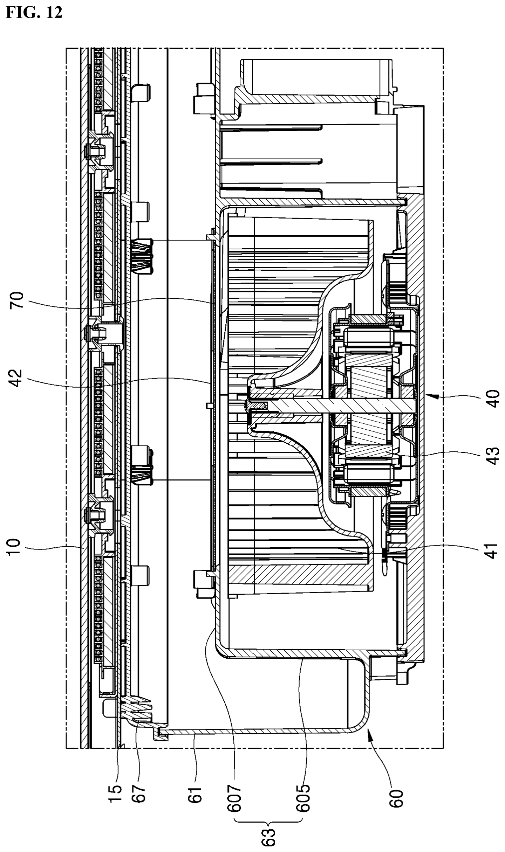

FIG. 9 is a perspective view illustrating the exhaust device in a disassembled state, and FIG. 10 is a perspective view illustrating an upper open state of the exhaust device shown in FIG. 9. FIG. 11 is an exploded perspective view illustrating a disassembled state of the exhaust device shown in FIG. 9, and FIG. 12 is a side cross-sectional view showing an internal structure of the exhaust device shown in FIG. 9.

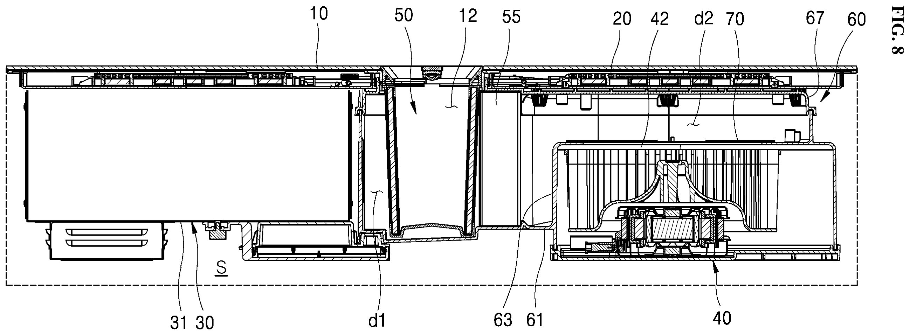

Referring to FIGS. 8 to 12, the fan 40 may be installed in the hood housing 60, and at least a portion of the fan 40 may be accommodated in the hood housing 60. The fan 40 may include an impeller 41 and a fan motor 43.

According to the present embodiment, the impeller 41 is provided to be rotatable about a vertical-direction axis, for example, a vertical axis. An internal space is formed inside the impeller 41, and air sucked by the impeller 41 may be introduced into the internal space.

The impeller 41 may be connected to a rotation shaft of the fan motor 43. A rotation shaft of the fan motor 43 rotates about a vertical-direction axis, and the impeller 41 connected to the rotation shaft of the fan motor 43 is rotatable about the vertical-direction axis.

As an example, the fan 40 may be provided in a form of a centrifugal fan. For example, the fan 40 may be provided in a form of a scroll fan. At least one of an upper end and a lower end of the fan 40 may be provided with an intake port 42. The fan 40 may suck air in a vertical direction through the intake port 42 and may discharge the sucked air in a horizontal direction.

According to the present embodiment, the intake port 42 is provided in the fan 40 and may be disposed on a side facing the top plate 10. As an example, the intake port 42 may be disposed at an upper portion of the fan 40 to open an inside of the fan 40 upward. For example, the intake port 42 may be provided at an upper end of the fan 40 to open a space inside the impeller 41 upward.

The fan 40 may suck air introduced into the component arrangement space S through the opening 12 and may suck air above the fan 40 through the intake port 42. The fan 40 sucking air through the intake port 42 in this way may discharge air in a direction different from a direction in which the intake port 42 opens an inside of the fan 40. For example, the fan 40 may suck air in a vertical direction through the intake port 42 and may discharge the sucked air in a horizontal direction.

The fan 40 may further include a fan housing 63. The fan housing 63 forms an outer appearance of the fan 40 and may accommodate the impeller 41 therein.

In the present embodiment, the fan housing 63 is exemplified as being formed in a scroll shape. A space accommodating the impeller 41 may be formed inside the fan housing 63. An inner circumferential surface of the fan housing 63 facing the internal space may be formed as a curved surface surrounding an outer circumferential surface of the impeller 41.

An intake port 42 may be formed at an upper portion of the fan housing 63. The intake port 42 may form a passage in the fan housing 63 required for air outside the fan 40 to be sucked into the inside of the impeller 41.

The fan housing 63 may be provided with an exhaust port 44. The exhaust port 44 forms a passage required for air sucked into the inside of the fan housing 63 by the impeller 41 to be discharged to an outside of the fan 40.

The exhaust port 44 may be formed to penetrate the fan housing 63 in a horizontal direction. Accordingly, air sucked into the inside of the fan 40 in a vertical direction through the intake port 42 may be discharged from the fan 40 in a horizontal direction through the exhaust port 44.

As an example, the exhaust port 44 may be disposed at a rear portion of the fan housing 63. In this case, air sucked into the fan 40 may be discharged rearward and may be discharged to the outside of the cooking appliance through a rear portion of the cooking appliance.

As another example, the exhaust port 44 may be disposed at a side portion of the fan housing 63. In this case, air sucked into the fan 40 may be discharged laterally and may be discharged to the outside of the cooking appliance through a side portion of the cooking appliance.

### [Filter]

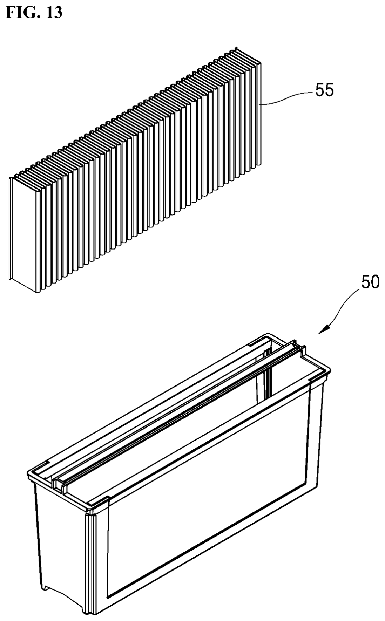

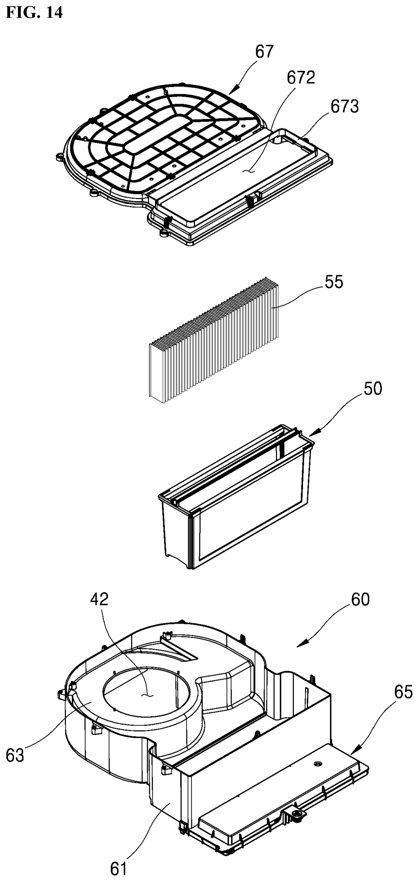

FIG. 13 is a view illustrating a state in which a filter is separated from the exhaust device, and FIG. 14 is an exploded perspective view illustrating a disassembled state of the hood housing and the filter.

According to the present embodiment, as shown in FIGS. 8, 10, and 13 to 14, at least a portion of the filter 50, 55 may be disposed in the air flow path d1, d2. For example, an air flow path d1, d2 is formed inside the hood housing 60, and at least a portion of the filter 50, 55 may be accommodated inside the hood housing 60.

The exhaust device according to the present embodiment may include a plurality of filters 50, 55. As an example, the exhaust device may include a first filter 50 and a second filter 55.

The first filter 50 may be disposed in the component arrangement space S. For example, the first filter 50 may be disposed between the opening 12 and the fan 40.

The first filter 50 may be disposed inside the hood housing 60 and may be disposed on the air flow path d1, d2. The first filter 50 may be installed in a region through which contaminated air first passes inside the exhaust device.

The first filter 50 may be provided for primarily purifying contaminated air including greases. As an example, the first filter 50 may be provided as a grease filter.

The first filter 50 may be formed in a porous structure. The first filter 50 may be provided as a filter having a structure capable of effectively collecting oily substances and large particles of contaminants while not interfering with air flow.

An upper portion of the first filter 50 is opened upward toward the opening 12, and a space capable of temporarily retaining contaminated air may be formed inside the first filter 50. Contaminated air flowing downward from the opening 12 toward the inside of the first filter 50 may be temporarily retained in the first filter 50 and then may pass through the first filter 50 in a horizontal direction.

Contaminated air introduced into the inside of the first filter 50 from the opening 12 comes into contact with wall surfaces of the first filter 50 while being temporarily retained inside the first filter 50. When contaminated air contacts the wall surfaces of the first filter 50 inside the first filter 50, oily substances or large particles of contaminants in the contaminated air adhere to or stick to the wall surfaces of the first filter 50 and are separated from the contaminated air. In this way, air from which oily substances or large particles of contaminants are removed passes through the first filter 50.

The second filter 55, similarly to the first filter 50, may be disposed inside the hood housing 60 and may be disposed on the air flow path d1, d2. The second filter 55 may be disposed between the first filter 50 and the fan 40. That is, in a horizontal direction, the second filter 55 may be disposed between the first filter 50 and the intake port 42.

The second filter 55 may be provided for further purifying contaminated air that has passed through the first filter 50. As an example, the second filter 55 may be a charcoal filter.

The second filter 55 may perform a role of removing gaseous contaminants such as remaining odor components and volatile organic compounds (VOC) in the contaminated air primarily purified by the first filter 50. Accordingly, the second filter 55 may improve cleanliness of air finally discharged to the outside of the exhaust device.

The first filter 50 and the second filter 55 may be sequentially disposed at positions spaced apart from each other on an air flow path, that is, the air flow path d1, d2. In addition, the arrangement thereof may be set so that the first filter 50 is disposed to precede and the second filter 55 is disposed to follow along a flow direction of contaminated air. Accordingly, each filter 50, 55 may perform complementary purification functions, thereby improving overall contaminant removal efficiency.

### [Hood housing]

Referring to FIGS. 8 to 11 and 14, the filters 50, 55 may be accommodated in the hood housing 60. The hood housing 60 is provided to accommodate at least a portion of the fan 40 and the first filter 50 and the second filter 55.

The hood housing 60 may include an outer wall part 601 and a bottom part 603. The outer wall part 601 and the bottom part 603 are provided to form an outer appearance of the hood housing 60.

The outer wall part 601 may define a horizontally outer boundary surface of the hood housing 60, and the bottom part 603 may define a vertically outer boundary surface. For example, the outer wall part 601 may form a front surface, a rear surface, and both side surfaces of the hood housing 60, and the bottom part 603 may form a lower surface of the hood housing 60.

An internal space for accommodating the fan 40, the filters 50, 55, and the like may be formed inside the hood housing 60, and a portion of the hood housing 60 may be opened upward.

According to the present embodiment, the hood housing 60 may include a flow path forming part 61. The flow path forming part 61 may be disposed between the opening 12 and the fan 40, and an air flow path d1, d2 may be formed inside the flow path forming part 61. That is, the air flow path d1, d2 is formed inside the flow path forming part 61, and the air flow path d1, d2 may connect the opening 12 and the fan 40.

The flow path forming part 61 may include filter housing parts 611, 613. Spaces for accommodating the filters 50, 55 may be formed in the filter housing parts 611, 613. As an example, the flow path forming part 61 may include a first filter housing part 611 for accommodating the first filter 50 and a second filter housing part 613 for accommodating the second filter 55.

The first filter housing part 611 is provided to accommodate the first filter 50, and the second filter housing part 613 is provided to accommodate the second filter 55. On an air flow path, the first filter housing part 611 may be disposed between the opening 12 and the fan 40, and the second filter housing part 613 may be disposed between the first filter housing part 611 and the fan 40.

In a horizontal direction, the second filter housing part 613 may be disposed between the first filter housing part 611 and the fan 40. The first filter housing part 611 and the second filter housing part 613 may be connected in a horizontal direction. For example, the second filter housing part 613 may be disposed on a right side of the first filter housing part 611, the fan 40 may be disposed on a right side of the second filter housing part 613, and the first filter housing part 611 and the second filter housing part 613 may be connected in a left-right direction.

An internal space of the first filter housing part 611 and the second filter housing part 613 connected in the horizontal direction as described above may be formed with a first flow path d1. The first flow path d1 may be opened toward the opening 12 in the first filter housing part 611 and may be opened toward the fan 40 in the second filter housing part 613. For example, the first flow path d1 may be opened upward in the first filter housing part 611 and may be opened to a right side in the second filter housing part 613.

The first filter 50 may be disposed in the first filter housing part 611 on the first flow path d1, and the second filter 55 may be disposed in the second filter housing part 613 on the first flow path d1. The first flow path d1 is connected to the opening 12, and contaminated air outside the cooking appliance may be introduced into the first flow path d1 through the opening 12. Air introduced into the first flow path d1 in this way may pass through the first filter 50 accommodated in the first filter housing part 611 and the second filter 55 accommodated in the second filter housing part 613 in order and then may flow toward the fan 40.

The first filter housing part 611 and the second filter housing part 613 may be partitioned by a partition wall 602. The partition wall 602 may be a portion of the outer wall part 601. More specifically, at least a portion of an area disposed between the first filter housing part 611 and the second filter housing part 613 among the outer wall part 601 may be formed as the partition wall 602. The partition wall 602 may be formed in a form of a vertical wall surface in which a portion of the outer wall part 601 protrudes toward an inside of the hood housing 60 in a horizontal direction.

As an example, a pair of partition walls 602 may be disposed in a front-rear direction between the first filter housing part 611 and the second filter housing part 613. For example, one of the pair of partition walls 602 may be formed in a form in which a portion of a front surface of the outer wall part 601 protrudes rearward toward the inside of the hood housing 60. Another one of the pair of partition walls 602 may be formed in a form in which a portion of a rear surface of the outer wall part 601 protrudes forward toward the inside of the hood housing 60.

A connection hole 612 may be formed between the first filter housing part 611 and the second filter housing part 613. The connection hole 612 may form a passage connecting the first filter housing part 611 and the second filter housing part 613. Air introduced into the first flow path d1 and passing through the first filter 50 may flow toward the second filter 55 through the connection hole 612.

As an example, the connection hole 612 may be formed in a shape penetrating between the first filter housing part 611 and the second filter housing part 613 in a left-right direction. The connection hole 612 may be disposed between the first filter housing part 611 and the second filter housing part 613 in the left-right direction and may be disposed between the pair of partition walls 602 in the front-rear direction.

The connection hole 612 may connect an inside of the first filter housing part 611 and an inside of the second filter housing part 613 in a horizontal direction and may be formed to allow the second filter 55 to pass through the connection hole 612 in the horizontal direction. That is, the connection hole 612 may form a passage required for the second filter 55 to move from the first filter housing part 611 to the second filter housing part 613 through the connection hole 612.

Both the first filter 50 and the second filter 55 may be inserted into the inside of the hood housing 60 through the opening 12. The second filter 55 may move downward through the opening 12, then may be inserted into the first filter housing part 611, and thereafter may move in a horizontal direction to be inserted into the second filter housing part 613. In this way, assembly of the first filter 50 and the second filter 55 may be sequentially performed in a form in which the second filter 55 is first inserted into the inside of the hood housing 60 and then the first filter 50 is inserted into the inside of the hood housing 60 through the opening 12.

According to the present embodiment, a width of the second filter 55 may be set smaller than a width of the first filter 50. In the present embodiment, a "front-rear direction length" of the first filter 50 or the second filter 55 is defined as a "width" of the first filter 50 or the second filter 55.

The width of the first filter 50 may be set to be less than or equal to a width of the first filter housing part 611. A width of the connection hole 612 may be set to be greater than or equal to the width of the second filter 55 and less than the width of the first filter 50. Accordingly, the second filter 55 may move from the first filter housing part 611 to the second filter housing part 613 through the connection hole 612, but the first filter 50 may not pass through the connection hole 612.

That is, the second filter 55 may easily move from the first filter housing part 611 to the second filter housing part 613 through an area in which the partition wall 602 is disposed, but the first filter 50 is caught by the partition wall 602 in the first filter housing part 611 and may not move to the second filter housing part 613. Accordingly, the first filter 50 and the second filter 55 may be installed to be clearly separated at different positions.

The hood housing 60 may further include a fan housing part 63. The fan housing part 63 is provided to accommodate at least a portion of the fan 40. At least a portion of the fan housing part 63 may be accommodated inside the hood housing 60.

According to the present embodiment, the flow path forming part 61 may be disposed in a space surrounded by the outer wall part 601 and the bottom part 603 of the hood housing 60. That is, a horizontally outer boundary surface of the flow path forming part 61 may be defined by the outer wall part 601, and a lower surface of the flow path forming part 61 may be defined by the bottom part 603.

Similarly to the flow path forming part 61, the fan housing part 63 may be disposed in a space surrounded by the outer wall part 601. That is, the fan housing part 63 is disposed inside the hood housing 60, and the flow path forming part 61 may accommodate at least a portion of the fan housing part 63 therein. At least a portion of the fan 40 may be accommodated in the fan housing part 63 and may be disposed inside the hood housing 60.

The fan housing part 63 may include an inner wall part 605 surrounding the fan 40 from a horizontally outer side. More specifically, the fan housing part 63 may be formed in a form of a vertical wall surface surrounding the intake port 42 from a horizontally outer side. As an example, the inner wall part 605 may be formed in a substantially cylindrical wall surface shape protruding upward from the bottom part 603 of the hood housing 60.

In addition, the fan housing part 63 may further include an upper surface part 607. The upper surface part 607 is disposed above the inner wall part 605 and may form an upper surface of the fan housing part 63. As an example, the upper surface part 607 may be formed in a ring shape covering an upper portion of the inner wall part 605. A hollow penetrating the upper surface part 607 in a vertical direction may be formed inside the upper surface part 607, and the intake port 42 may be opened upward through the hollow.

According to the present embodiment, an upper end of the inner wall part 605 and the upper surface part 607, that is, an upper end of the fan housing part 63, may be disposed between the intake port 42 and the top plate 10. A second flow path d2 connecting the first flow path d1 and the intake port 42 may be formed between the upper end of the fan housing part 63 and the top plate 10. Air passing through the first filter 50 and the second filter 55 in the first flow path d1 may be sucked into the fan 40 through the intake port 42 via the second flow path d2.

The second flow path d2 may be disposed above the fan 40 and the intake port 42. That is, air passing through the first filter 50 and the second filter 55 in the first flow path d1 may be introduced into an inside of the fan 40 through a flow path formed above the fan 40 and the intake port 42.

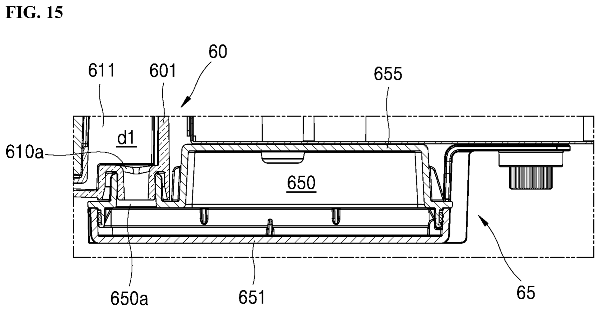

When viewed from a lower side, as shown in FIGS. 8 and 15, the fan housing part 63 may have a shape recessed upward from a lower surface of the hood housing 60. That is, a space 606 (hereinafter, referred to as a "fan housing space") formed as a result of a portion of the bottom part 603 being recessed upward may be formed in the fan housing part 63, and at least a portion of the fan 40 may be inserted into the fan housing space 606.

At least a portion of a rear part of the fan housing space 606 may be opened rearward, and the exhaust port 44 may be exposed to an outside of the fan housing 63 through the rear part of the fan housing space 606 opened in this way.

As an example, the fan housing 63 may be integrally formed with the hood housing 60. For example, the fan housing part 63 provided in the hood housing 60 may be formed in a shape corresponding to a shape of the fan housing 63. As another example, the fan housing 63 may be provided in the hood housing 60 in a form replacing the fan housing part 63.

As still another example, the fan housing may be provided separately from the hood housing 60. For example, the fan housing may be coupled to the hood housing 60 in a state in which at least a portion of the fan housing 63 is inserted into the fan housing part 63.

Meanwhile, the exhaust device may further include a housing cover 67. The housing cover 67 is provided to cover an opened upper portion of the hood housing 60. In a vertical direction, the housing cover 67 may be disposed between the top plate 10 and the hood housing 60, more specifically, between the heating unit case 15 and the hood housing 60.

The housing cover 67 may cover the opened upper portion of the hood housing 60 and may be coupled to an upper end of the outer wall part 601. The hood housing 60 is provided with the filter housing parts 611 and 613 and the fan housing part 63, and the housing cover 67 may cover at least a portion of the filter housing parts 611 and 613 and the fan housing part 63 and may be coupled to the hood housing 60. In a space surrounded by the hood housing 60 and the housing cover 67 coupled as described above, the flow paths d1 and d2 may be formed.

According to the present embodiment, the housing cover 67 may form an upper boundary surface of the first flow path d1 and the second flow path d2. The first filter 50 and the second filter 55 disposed in the first flow path d1 may be accommodated in a space covered by the housing cover 67. A lower boundary surface of the second flow path d2 may be defined by the upper surface part 607 of the fan housing part 63, and an upper boundary surface of the second flow path d2 may be defined by the housing cover 67.

The second flow path d2 may be defined as a flow path formed above the fan 40, that is, a space formed between the intake port 42 of the fan 40 and the housing cover 67.

As another example, without the housing cover 67, the hood housing 60 and the heating unit case 15 may be directly coupled to each other. For example, the heating unit case 15 may cover an upper portion of the hood housing 60 and may be coupled to an upper end of the outer wall part 601, and the flow paths d1 and d2 may be formed in a space surrounded by the hood housing 60 and the heating unit case 15.

According to the present embodiment, the housing cover 67 may be disposed between the opening 12 and the hood housing 60, and a cover hole 672 may be provided in the housing cover 67. The cover hole 672 may be formed in a shape corresponding to the opening 12 formed in the top plate 10 and may be disposed to communicate with the opening 12. The cover hole 672 may form a passage connecting the opening 12 of the top plate 10 and the flow paths d1 and d2 in the housing cover 67.

In addition, the exhaust device may further include a fan base 69. The fan base 69 may be disposed below the fan housing 63 and is provided to cover a lower portion of the fan housing 63 from below.

The fan base 69 may be coupled to a lower portion of the fan housing 63. In addition, the fan base 69 may support the fan motor 43 from below. The fan base 69 may be coupled to a lower portion of the fan motor 43 and a lower portion of the fan housing 63 to support the fan motor 43 on the fan housing 63.

### [Fluid collecting part]

FIG. 15 is a front cross-sectional view showing an internal structure of a fluid collection part according to one embodiment of the present disclosure.

Referring to FIGS. 7 and 15, the exhaust device according to the present embodiment may further include a fluid collecting part 65. The fluid collecting part 65 is provided to collect a fluid separated from air by the filters 50 and 55. More specifically, the fluid collecting part 65 is provided as a structure for collecting a liquid fluid, such as oil components falling from contaminated air passing through the first filter 50 (hereinafter, referred to as "liquid fluid").

The fluid collecting part 65 may be disposed to be horizontally spaced apart from the fan 40 with the opening 12 interposed therebetween. The fan 40 and the fluid collecting part 65 may be disposed to be horizontally spaced apart from each other with the filters 50 and 55 interposed therebetween.

According to the present embodiment, at least a portion of the filters 50 and 55 may be disposed on the flow paths d1 and d2. More specifically, the filters 50 and 55 may be disposed on the first flow path d1. The fluid collecting part 65 may be disposed outside the flow paths d1 and d2. The fluid collecting part 65 may be disposed to be horizontally spaced apart from the fan 40 with the flow paths d1 and d2 interposed therebetween.

Air introduced into the first flow path d1 through the opening 12 is filtered by the filters 50 and 55. Liquid fluid filtered by the first filter 50 may flow out of the flow paths d1 and d2 and may be collected in the fluid collecting part 65.

As an example, the fan 40 may be disposed on a left side of the opening 12 and the filters 50 and 55, and the fluid collecting part 65 may be disposed on a right side of the opening 12 and the filters 50 and 55. In this case, contaminated air introduced through the opening 12 may flow leftward toward the second filter 55 and the fan 40 after passing through the first filter 50, and liquid fluid filtered by the first filter 50 may be collected in the fluid collecting part 65 disposed on a right side of the filters 50 and 55.

The fluid collecting part 65 may be provided to be connected to the hood housing 60. The fluid collecting part 65 may be connected to the flow path forming part 61 such that an internal space of the fluid collecting part 65 communicates with an internal space of the flow path forming part 61. More specifically, the fluid collecting part 65 may be connected to the flow path forming part 61 such that the internal space of the fluid collecting part 65 communicates with the first flow path d1.

In addition, the fluid collecting part 65 may be disposed to be horizontally spaced apart from the fan 40 with the flow path forming part 61 interposed therebetween. The fluid collecting part 65 may be disposed in a form protruding in a horizontal direction from the flow path forming part 61. As an example, the fluid collecting part 65 may be disposed in a form protruding in a direction away from the fan 40.

Liquid fluid contained in contaminated air introduced into the first filter housing part 611 may be filtered by the first filter 50 and may be collected on a bottom surface of the hood housing 60, more specifically, on a bottom surface of the first filter housing part 611, and a portion of liquid fluid not filtered by the first filter 50 may be attached to the outer wall part 601. The liquid fluid attached to the outer wall part 601 in this way may flow downward along the outer wall part 601 and may be collected on the bottom surface of the hood housing 60.

A collecting space 650 for accommodating fluid filtered from air by the filters 50 and 55 may be formed inside the fluid collecting part 65. When the fluid collecting part 65 is connected to the hood housing 60, the collecting space 650 may be connected to an internal space of the hood housing 60 in which liquid fluid is collected. Accordingly, liquid fluid collected on the bottom surface of the hood housing 60 may be introduced into the fluid collecting part 65 and may be accommodated in the collecting space 650.

A discharge port 610a may be formed in the bottom surface of the hood housing 60, and an inlet port 650a may be formed in the fluid collecting part 65 disposed below the hood housing 60. The discharge port 610a may form a passage opening an inside of a filter housing part, more specifically, an inside of the first filter housing part 611, to an outside of the hood housing 60 on the bottom surface of the hood housing 60. The inlet port 650a may form a passage connecting a space in which a filter is accommodated, for example, an internal space of the first filter housing part 611, and the collecting space 650 in the fluid collecting part 65.

The fluid collecting part 65 may include a collection tray 651. The collection tray 651 forms a lower structure of the fluid collecting part 65. The collection tray 651 may collect liquid fluid introduced into the collecting space 650 through the inlet port 650a. For example, a bottom surface of the collection tray 651 may form a bottom surface of the fluid collecting part 65, and liquid fluid introduced into the collecting space 650 may be retained on the bottom surface of the collection tray 651.

The fluid collecting part 65 may further include a tray cover 655. The tray cover 655 forms an upper structure of the fluid collecting part 65. The tray cover 655 may be coupled to the collection tray 651 and may form the collecting space together with the collection tray 651.

As an example, an internal space of the collection tray 651 may be opened upward, and an internal space of the tray cover 655 may be opened downward. In this case, the tray cover 655 may cover an opened upper portion of the collection tray 651 and may be coupled to the collection tray 651, and the collecting space 650 may be formed inside the collection tray 651 and the tray cover 655 coupled in this way.

The inlet port 650a may be formed in the tray cover 655. When the tray cover 655 is coupled to a lower side of the hood housing 60, the inlet port 650a may be connected to the discharge port 610a. By connection between the inlet port 650a and the discharge port 610a, an internal space of the first filter housing part 611 and the collecting space 650 are connected, and liquid fluid collected in the internal space of the first filter housing part 611 may be introduced into the collecting space 650.

### [Arrangement structure of fan, filters, fluid collecting part, and electric component part]

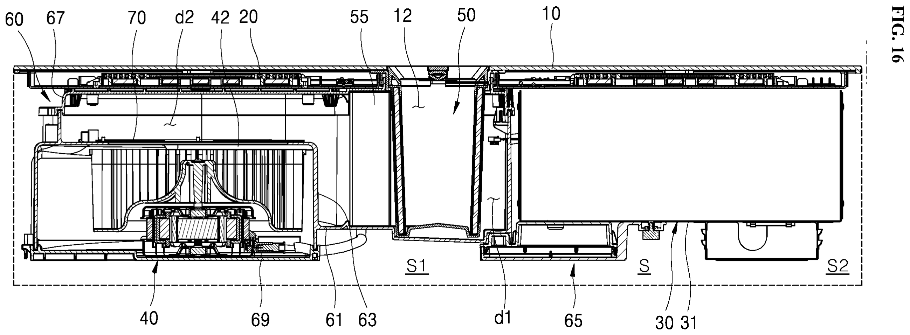

FIG. 16 is a front cross-sectional view showing a component arrangement state in a component arrangement space.

As shown in FIG. 16, the opening 12 may be disposed between the fan 40 and the electric component part 30. That is, the fan 40 and the electric component part 30 may be disposed to be spaced apart from each other in a horizontal direction with the opening 12 interposed therebetween. In the present embodiment, the fan 40 and the electric component part 30 are exemplified as being disposed to be spaced apart from each other in a left-right direction with the opening 12 interposed therebetween.

According to the present embodiment, the component arrangement space S (see FIG. 7) may be divided into two divided spaces disposed in the left-right direction. Among the two divided spaces, one may be used as a space for accommodating components involved in a flow of contaminated air introduced through the opening 12, and the other may be used as a space for accommodating electric components that are not involved in suction and discharge of contaminated air.

For example, the divided space S1 (hereinafter, referred to as a "first space"), which is disposed at one of a left side or a right side of the opening 12, may have the fan 40 and the filters 50 and 55 disposed therein, and the divided space S2 (hereinafter, referred to as a "second space"), which is disposed at the other of the left side or the right side of the opening 12, may have the electric component part 30 disposed therein. In the present embodiment, a case in which the first space S1 is disposed on a left side of the opening 12 and the second space S2 is disposed on a right side of the opening 12 is exemplified.

In order to secure suction performance of the exhaust device for contaminated air, a size of the fan 40 needs to be sufficiently large. As the size of the fan 40 increases, suction performance increases, but the fan 40 correspondingly occupies a significant region of the component arrangement space S. Meanwhile, since the cooking appliance is generally disposed above an oven or a dishwasher, structural constraints are imposed on expansion of the component arrangement space S in a vertical direction.

Accordingly, rather than being stacked in the vertical direction, the fan 40 and the filters 50 and 55 are preferably disposed side by side along a horizontal direction. As a result, air introduced through the opening 12 flows along the flow paths d1 and d2 extending in the horizontal direction.

In addition, the fan 40 and the filters 50 and 55 are preferably disposed to be accommodated in only one of the first space S1 and the second space S2.

If the fan 40 is disposed in the first space S1 while at least one of the first filter 50 and the second filter 55 is disposed in the second space S2, or if the fan 40 is disposed on a right side of the opening 12 while at least one of the first filter 50 and the second filter 55 is disposed on a left side of the opening 12, a bent portion inevitably occurs in the flow paths d1 and d2.

For example, when the fan 40 is disposed in the first space S1 and the first filter 50 and the second filter 55 are disposed in the second space S2, a bent section for direction change is formed between a section of the flow paths d1 and d2 extending rightward from the opening 12 toward the first filter 50 and a section extending leftward from the second filter 55 toward the fan 40. Such a bent section of the flow paths d1 and d2 causes an increase in flow resistance.

In consideration of the above, in the present embodiment, the fan 40 and the filters 50 and 55 are disposed to be accommodated in only one of the first space S1 and the second space S2. Accordingly, the flow paths d1 and d2 connecting the opening 12, the filters 50 and 55, and the fan 40 may be formed to be substantially straight without a bent section for direction change.

As the fan 40 and the filters 50 and 55 are disposed to be accommodated in only one of the first space S1 and the second space S2, most of the corresponding space is occupied by the fan 40 and the filters 50 and 55. Accordingly, the electric component part 30 may be disposed in the other one of the first space S1 and the second space S2. For example, when the fan 40 and the filters 50 and 55 are disposed in the first space S1, the electric component part 30 is disposed in the second space S2 in which the fan 40 and the filters 50 and 55 are not disposed.

As the fan 40 and the filters 50 and 55 are disposed to be accommodated in only one of the first space S1 and the second space S2, sufficient free space is secured in the other one of the first space S1 and the second space S2, and the electric component part 30 may be disposed in the secured free space.

That is, by the above-described arrangement structure of the fan 40 and the filters 50 and 55, not only arrangement efficiency of the fan 40 and the filters 50 and 55 is secured, but also advantages of reducing flow resistance and securing a space required for arranging the electric component part 30 may be provided.

According to the present embodiment, the filters 50 and 55 may be disposed at approximately a center of the component arrangement space S in the left-right direction. For example, when the opening 12 is disposed at the left-right center of the component arrangement space S, the first filter 50 may be disposed directly below the opening 12, and the second filter 55 may be disposed at a position slightly shifted leftward therefrom.

In the horizontal direction, the filters 50 and 55 may be disposed to block between the fan 40 and the fluid collecting part 65, and between the fan 40 and the electric component part 30. The fan 40 may be disposed on a left side of the filters 50 and 55, and the electric component part 30 may be disposed on a right side of the filters 50 and 55. The fluid collecting part 65 may also be disposed on a right side of the filters 50 and 55.

In the vertical direction, at least a portion of the fluid collecting part 65 may be disposed below the filters 50 and 55, more specifically, below the first filter 50. For example, the fluid collecting part 65 may be disposed such that a bottom surface of the collection tray 651, in which the liquid fluid is accumulated, is disposed at a position lower than a lower end of the first filter 50.

This is to allow a collection position of the liquid fluid to be located at a position lower than the first filter 50. As the fluid collecting part 65 is disposed at a position lower than the first filter 50 in this manner, the liquid fluid filtered by the first filter 50 may be effectively collected in the collection tray 651.

The fluid collecting part 65 as described above may be disposed together with the electric component part 30 in the same space, for example, in the second space S2. In other words, the fluid collecting part 65 may be disposed in the divided space in which the fan 40 is not disposed, that is, in the divided space other than the first space S1.

The size of the fluid collecting part 65 is closely related to a collection capacity of the liquid fluid. When the collection capacity of the fluid collecting part 65 is small, not only inconvenience of frequently emptying the liquid fluid may occur, but also a risk that the liquid fluid overflows and leaks from the fluid collecting part 65 may increase.

To increase the size of the fluid collecting part 65, it is necessary to increase a length in the vertical direction or a length in the horizontal direction. However, increasing the length upward has no substantial effect, and since an installation position of the fluid collecting part 65 is already located at a considerably low position, structural limitations are imposed on extending the length downward.

In view of these points, to increase the size of the fluid collecting part 65, it is preferable to increase a length in the horizontal direction. However, considering that the fluid collecting part 65 and the electric component part 30 share the same space, there is also a limitation in indefinitely increasing a length of the fluid collecting part 65 in the horizontal direction.

In consideration of such structural constraints, the present embodiment proposes a configuration in which the fluid collecting part 65 is disposed at a position lower than the electric component part 30. That is, in the vertical direction, the fluid collecting part 65 may be disposed below the electric component part 30 such that the electric component part 30 is disposed between the top plate 10 and the fluid collecting part 65.

While the fan 40 is a component that requires a sufficient length in the vertical direction to enhance performance, the electric component part 30 only needs to secure a size sufficient to stably accommodate internal electric components. In particular, to efficiently dispose the electric components in the electric component part 30, a space in the horizontal direction is more important than a space in the vertical direction, and securing a sufficient length in the horizontal direction is more advantageous in terms of arrangement efficiency.

Thus, unlike the fan 40, the electric component part 30 does not need to be designed to be elongated in the vertical direction for performance improvement, and a vertical length sufficient to stably accommodate the internal electric components is sufficient. Accordingly, a certain level of free space may be secured below the electric component part 30, and the free space may serve as a potential installation area for more efficiently utilizing an internal space of the cooking appliance.

In particular, such lower free space may be effectively used as an installation space for securing the size of the fluid collecting part 65. For this purpose, the fluid collecting part 65 is preferably disposed at a position lower than the electric component part 30, that is, at a position corresponding to a free space formed below the electric component part 30. Such an arrangement structure provides an advantage of maximizing space efficiency inside the cooking appliance while sufficiently securing a collection capacity of the fluid collecting part 65.

### [Electric component part]

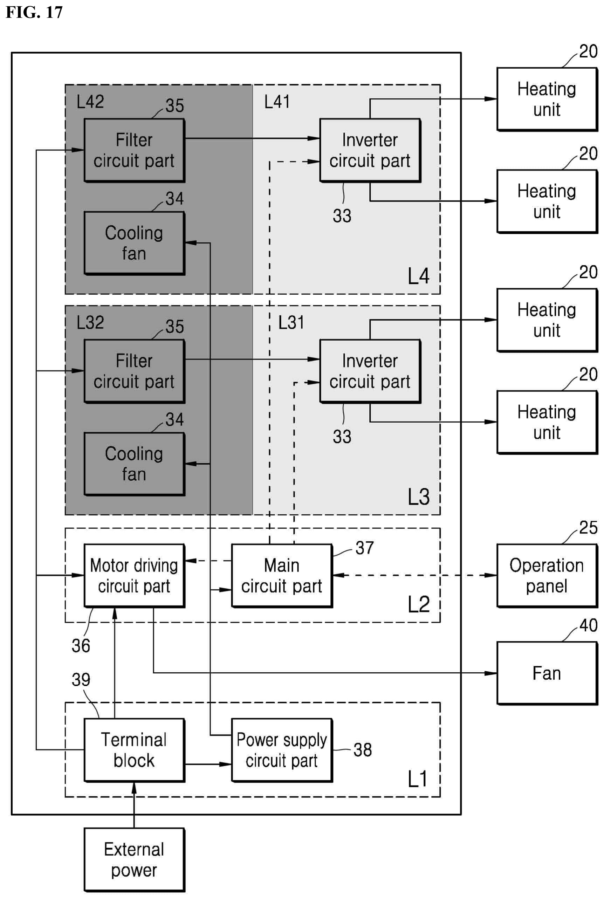

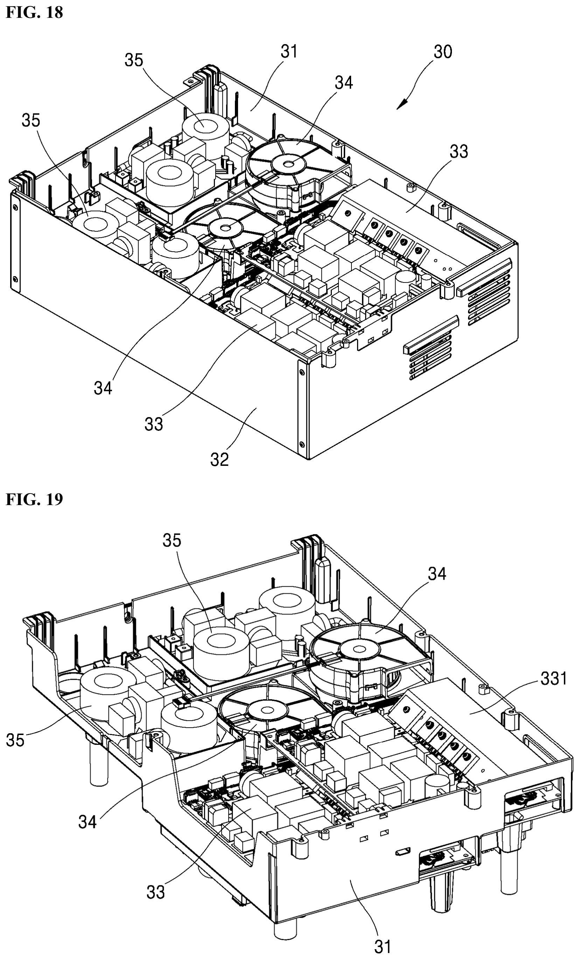

FIG. 17 is a block diagram illustrating a configuration of a cooking appliance according to an embodiment of the present disclosure, and FIG. 18 is a perspective view illustrating the electric component part separated from the cooking appliance according to an embodiment of the present disclosure.

Referring to FIGS. 16 to 17, the electric component part 30 is disposed in the component arrangement space S provided below the top plate 10. The component arrangement space S is a space in which the fan 40, the filter 50, the fluid collecting part 65, and the electric component part 30 are disposed together, and a shape in the horizontal direction and size thereof are substantially limited by a range covered by the top plate 10. Accordingly, the electric component part 30 needs to be disposed efficiently within an available region of the component arrangement space S.

An upper boundary of the component arrangement space S may be defined by a lower surface of the top plate 10. A lower boundary of the component arrangement space S is not defined by a separate structure, but may be substantially determined according to lower-end positions of the components such as the fan 40, the filter 50, the fluid collecting part 65, the electric component part 30, and the like.

Among these, the fan 40 is a component that requires the greatest height (thickness) in terms of performance, and thus acts as a reference element that determines an overall height of the component arrangement space S. Accordingly, in order for the electric component part 30 to be disposed in the component arrangement space S, a vertical direction dimension of the electric component part 30 needs to be designed to be not greater than a vertical direction length of the fan 40.

The electric component part 30 may include an electric component housing part and a plurality of circuit parts. The electric component housing part may form therein a plurality of electric component spaces L1 to L4 arranged in a vertical direction. In each of the electric component spaces L1 to L4, at least one of the plurality of circuit parts may be disposed.

The electric component housing part may include an electric component supporter 31. The electric component supporter 31 is provided to support at least one of the plurality of circuit parts. In addition, the electric component housing part may include an electric component case 32. The electric component case 32 may form an exterior of the electric component part 30 and may accommodate the electric component supporter 31 therein. Further, the electric component case 32 may accommodate therein various electric components including the plurality of circuit parts.

According to the present embodiment, an internal space of the electric component housing part may be defined as an internal space of the electric component case 32. The internal space of the electric component housing part may be divided into a plurality of electric component spaces L1 to L4 by the electric component supporter 31. For example, a plurality of electric component spaces L1 to L4 may be arranged in a vertical direction inside the electric component housing part, and each of the electric component spaces L1 to L4 may be partitioned by the electric component supporter 31.

For example, a first electric component space L1 and a second electric component space L2 may be arranged in the vertical direction below the electric component supporter 31, and a third electric component space L3 and a fourth electric component space L4 may be arranged in the vertical direction inside the electric component supporter 31.

Through this, an interior of the electric component part 30 may form a multi-stage structure, and circuit parts and related electric components may be disposed on each stage. Such a multi-stage structure contributes to allowing a plurality of circuit parts and electric components to be effectively accommodated while minimizing a dimension of the electric component part 30 in the horizontal direction, thereby enabling the electric component part 30 to be efficiently disposed in a limited space in the component arrangement space S.

Referring to FIGS. 17 and 18, the electric component part 30 may include a first circuit part 33. The first circuit part 33 may be disposed in at least one of the plurality of electric component spaces L1 to L4, and may include an inverter circuit part 33 for controlling an operation of the heating unit 20 of the cooking appliance.

The inverter circuit part 33 converts an alternating current power supplied from the outside into direct current, and then converts the direct current into alternating current power having a desired frequency and voltage to apply the alternating current power to the heating unit 20, thereby precisely adjusting a heating power and control characteristics of the heating unit 20. For convenience of description, hereinafter, the inverter circuit part 33 will be used with the same meaning as the first circuit part 33.

The heating unit 20 includes a working coil configured to generate an induced current in a cooking container disposed on a cooktop to heat a heating target, and the working coil may be driven by power supplied from the inverter circuit part 33. The inverter circuit part 33 may precisely adjust a cooking temperature and a heating intensity by controlling a voltage, a frequency, and the like applied to the working coil.

In the present embodiment, two heating units 20 are electrically connected to one first circuit part 33, that is, one inverter circuit part 33, and each first circuit part 33 is illustrated as independently controlling the corresponding heating units 20.

The inverter circuit part 33 includes a heat-generating element (e.g., an IGBT, a MOSFET, etc.) configured to perform high-speed switching, and the heat-generating element generates a significant amount of heat during operation. Accordingly, the inverter circuit part 33 may further include a heat dissipation member 331, such as a heat sink or a heat-dissipation plate, which is in thermal contact with the heat-generating element and is configured to dissipate heat to the outside. The heat dissipation member 331 may be formed as a protruding structure from the inverter circuit part 33, and the heat-generating element may be mounted on the heat dissipation member 331.

In addition, the electric component part 30 may further include various other electric components other than the first circuit part 33. For example, the electric component part 30 may further include a cooling fan 34. The cooling fan 34 may be provided to control high heat generated from the inverter circuit part 33.

The electric component part 30 may further include a filter circuit part 35. The filter circuit part 35 may be provided to suppress electromagnetic interference (EMI) generated in the inverter circuit part 33.

According to the present embodiment, at least one of the plurality of electric component spaces L1 to L4 may have the first circuit part 33, the cooling fan 34, and the filter circuit part 35 disposed together therein. This is to efficiently dissipate heat generated by operation of the first circuit part 33 and to suppress electromagnetic interference (EMI).

As the first circuit part 33, the cooling fan 34, and the filter circuit part 35 are disposed together in the same space and functionally interoperate with each other, operational stability of the circuit and thermal management efficiency may be improved at the same time.

In addition, the electric component part 30 may further include a motor driving circuit part 36 for driving the fan 40, a main circuit part 37 configured to control entire operation of the cooking appliance, and a power supply circuit part 38 for supplying power.

The power supply circuit part 38 is configured to receive alternating current (AC) power and convert the alternating current power into direct current (DC) power, and to stably supply the converted power to various circuits including the main circuit part 37, the first circuit part 33, and the cooling fan 34.

The main circuit part 37 is a central control circuit configured to control an entire system of the cooking appliance, and may generate a command for controlling operation of the first circuit part 33. The main circuit part 37 may process and control various signals required for cooking operations, such as a user operation input, temperature sensing, an operation timer, and heating intensity control, and may receive power from the power supply circuit part 38.

These electric components may be distributed and disposed in the electric component spaces L1 to L4 in consideration of space efficiency and thermal stability. By dividing an internal space of the electric component part 30 into multiple stages and vertically stacking the circuit parts at each stage, a highly functional electric circuit configuration may be realized without increasing an overall horizontal width of the cooking appliance.

Meanwhile, the cooking appliance may further include an operation panel 25. The operation panel 25 is provided so that a user may set various cooking conditions or check a cooking operation state.

The operation panel 25 may be electrically connected to the main circuit part 37 of the electric component part 30 to transmit various input signals to the main circuit part 37. For example, the operation panel 25 may be disposed at a front portion of the top plate 10 and may be disposed on a lower surface of the top plate 10. For example, the operation panel 25 may be installed on the lower surface of the top plate 10.

### [Electric component supporter]

FIG. 19 is a view showing a state in which an electric component case is removed from the electric component part shown in FIG. 18.

Referring to FIGS. 17 to 19, the electric component supporter 31 may include partition parts 311 and 312. The partition parts 311 and 312 may form horizontal planes that extend across the internal space of the electric component housing part in a horizontal direction. For example, the partition parts 311 and 312 may include a first partition part 311 and a second partition part 312.

At least a portion of the first partition part 311 and at least a portion of the second partition part 312 may each form horizontal planes located at different heights. In addition, the first partition part 311 and the second partition part 312 may be arranged in a lateral direction. For example, the first partition part 311 may be disposed below the second partition part 312, and the second partition part 312 may be disposed at a right side of the first partition part 311.

Upper surfaces of the first partition part 311 and the second partition part 312 may be provided as support surfaces for supporting the circuit parts, respectively, and may each form a bottom surface of the electric component supporter 31. Lower surfaces of the first partition part 311 and the second partition part 312 may each form a lower surface of the electric component supporter 31 facing a bottom surface of the electric component case 32. In addition, the first partition part 311 and the second partition part 312 may provide a function of blocking thermal crosstalk and electrical interference in the electric component spaces L1 to L4.

The electric component supporter 31 may include side wall parts 313. The side wall parts 313 may form vertical walls surrounding the partition parts 311 and 312 from a horizontal-direction outer side. The side wall parts 313 may form a front surface, a rear surface, and both side surfaces of the electric component supporter 31.

As described above, an internal space of the electric component housing part may be divided into a plurality of electric component spaces L1 to L4 by the electric component supporter 31. According to this, a first electric component space L1 and a second electric component space L2 may be disposed in a space between a bottom surface of the electric component case 32 and the second partition part 312, more specifically, between the bottom surface of the electric component case 32 and a lower surface of the electric component supporter 31, and a third electric component space L3 and a fourth electric component space L4 may be disposed inside the electric component supporter 31.

The second electric component space L2 may be disposed above the first electric component space L1, and a boundary between the second electric component space L2 and the third electric component space L3 arranged in a vertical direction may be formed by the lower surface of the electric component supporter 31. In addition, the fourth electric component space L4 may be disposed above the third electric component space L3, and a space between the third electric component space L3 and the fourth electric component space L4 arranged in the vertical direction may be partitioned by the second partition part 312.

Each of the electric component spaces L3 and L4 disposed inside the electric component supporter 31 may be further divided into a first divided space part L31 and L41 in which the first circuit part 33 is disposed, and a second divided space part L32 and L42 in which electric components other than the first circuit part 33 are disposed.

The electric component supporter 31 may be formed of an insulating material. For example, the electric component supporter 31 may be formed as an injection-molded article of a synthetic resin material. Such an electric component supporter 31 may effectively implement complex-shaped structures required for supporting and fastening electric components on the electric component supporter 31, and may be easily manufactured at a low cost.

In addition, the electric component supporter 31 formed as the injection-molded article of the synthetic resin material may allow effective electrical insulation among various electric components installed on the electric component supporter 31. Accordingly, the electric component supporter 31 may contribute to improving assemblability of the electric component part 30 and to preventing electrical abnormalities such as short circuits or leakage among the electric components.

### [Arrangement structure of electric components]

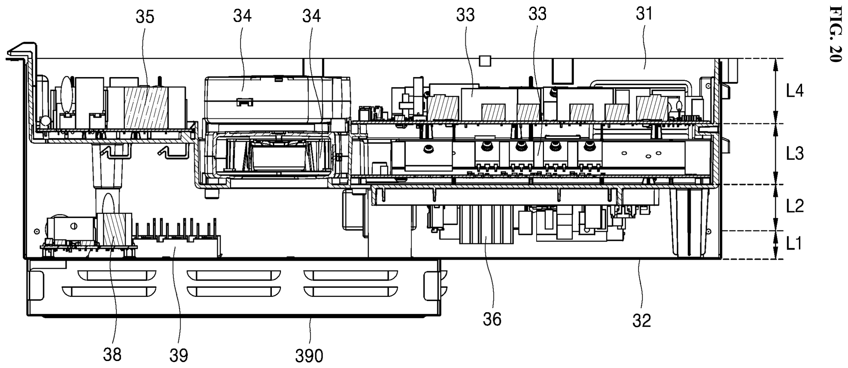

FIG. 20 is a side cross-sectional view showing an internal structure of the electric component part shown in FIG. 18.

Referring to FIGS. 16 to 20, an internal space of the electric component part 30 may be divided into a plurality of electric component spaces L1 to L4 arranged in a vertical direction, and various electric components may be distributed and disposed in each space according to functions. Each circuit part disposed in the internal space of the electric component part 30 may be one of a first circuit part 33 and a second circuit part forming different circuits.

According to the present embodiment, a plurality of first circuit parts 33 may be disposed in different spaces (a first separated arrangement structure), or the first circuit part 33 and the second circuit part may be disposed in different spaces (a second separated arrangement structure). Further, other electric components may be interposed between the first circuit part 33 and the second circuit part (a third separated arrangement structure). In the present embodiment, the inverter circuit part 33 corresponds to the first circuit part, and other circuit parts, for example, the filter circuit part 35, the motor driving circuit part 36, the main circuit part 37, and the power supply circuit part 38 correspond to the second circuit part.

Accordingly, a plurality of inverter circuit parts 33 may be disposed in different spaces (the first separated arrangement structure), the filter circuit part 35, the motor driving circuit part 36, the main circuit part 37, and the power supply circuit part 38 may be disposed in spaces different from the inverter circuit part 33 (the second separated arrangement structure), or other electric components may be interposed between the inverter circuit part 33 and any one of the filter circuit part 35, the motor driving circuit part 36, the main circuit part 37, and the power supply circuit part 38 (the third separated arrangement structure).

For example, in the third electric component space L3 and the fourth electric component space L4, that is, the electric component spaces disposed inside the electric component supporter 31, the inverter circuit part 33 may be disposed, and in the first electric component space L1 and the second electric component space L2, that is, the electric component spaces disposed below the electric component supporter 31, circuit parts other than the inverter circuit part 33 and the filter circuit part 35 may be disposed. This may correspond to an example of the first separated arrangement structure.

In addition, in the first electric component space L1 and the second electric component space L2, the motor driving circuit part 36, the main circuit part 37, and the power supply circuit part 38 may be disposed. For example, the first electric component space L1 and the second electric component space L2 may be arranged in a vertical direction, the power supply circuit part 38 may be disposed in the first electric component space L1, and the motor driving circuit part 36 and the main circuit part 37 may be disposed in the second electric component space L2. This implements a structure in which a plurality of second circuit parts are disposed in different electric component spaces, and may correspond to a form similar to the first separated arrangement structure.

The electric components disposed in the first electric component space L1 or the second electric component space L2 may be installed on a lower surface of the electric component supporter 31 or a bottom surface of the electric component case 32. Such a structure uses the lower surface of the electric component supporter 31 and the bottom surface of the electric component case 32 as installation surfaces, thereby stably supporting the electric components installed outside the electric component supporter 31, simplifying an assembly process, and increasing efficiency of component arrangement.

In addition, in the electric component part 30 of the present embodiment, some electric components, such as the main circuit part 37 and the power supply circuit part 38, are disposed in an outer space of the electric component supporter 31. Accordingly, the electric component part 30 of the present embodiment can efficiently secure a space required for essential circuit configurations for driving the cooking appliance while reducing a burden on utilization of an internal space of the electric component supporter 31.

The up-down two-stage structure of the electric component part 30 configured as described above contributes to implementing an optimized circuit arrangement by comprehensively considering functional roles, heat generation characteristics, electromagnetic interference, and wiring connection structures among the electric components. In particular, a circuit accommodating capacity can be expanded by two times or more within the same horizontal width, and reliability of the circuits, control precision, and maintainability can all be improved by minimizing interference among the components.

Further, the multi-stage structure in which the electric component spaces L1 to L4 are partitioned in the vertical direction allows various functional electric components to be efficiently accommodated without increasing a horizontal size of the electric component part 30, and enables a high-function electric system configuration to be realized even in a limited space below the top plate 10.

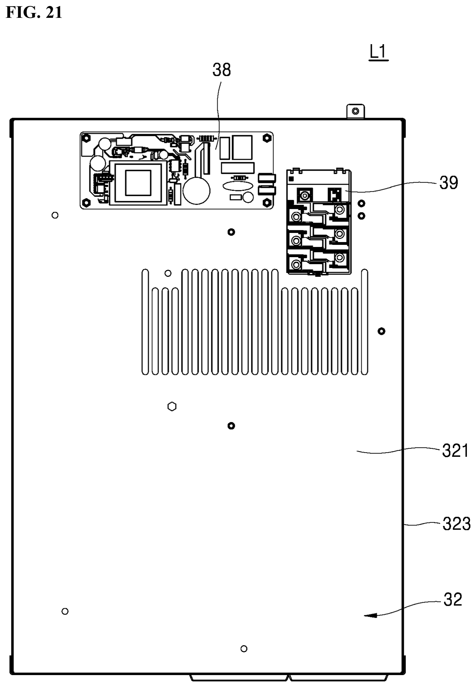

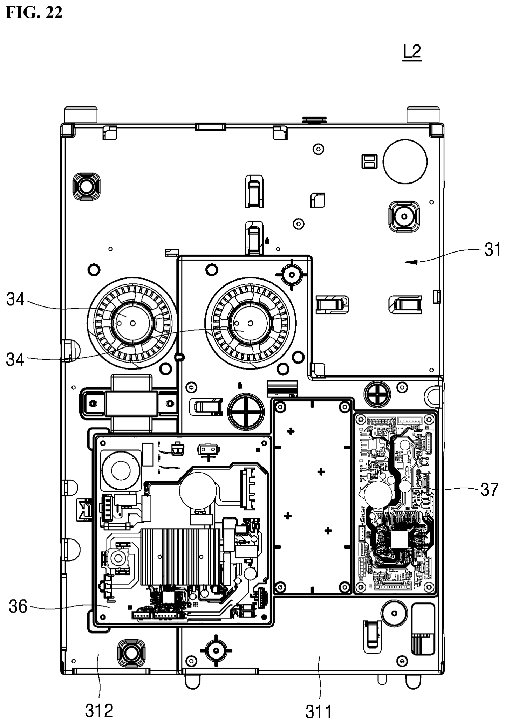

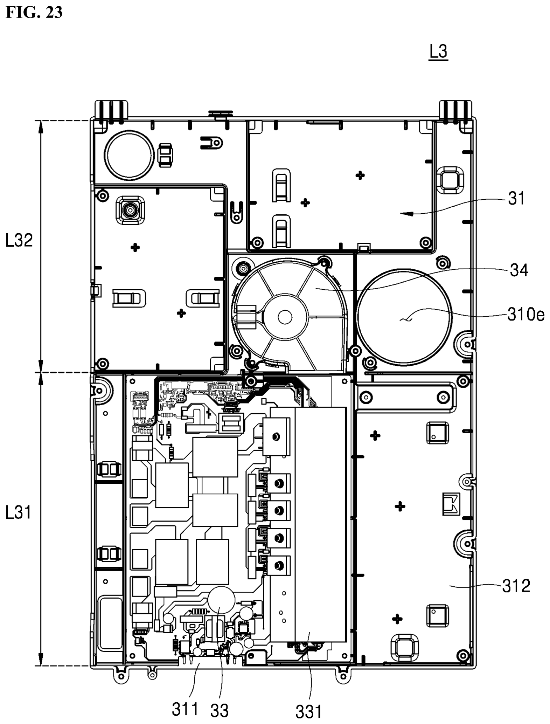

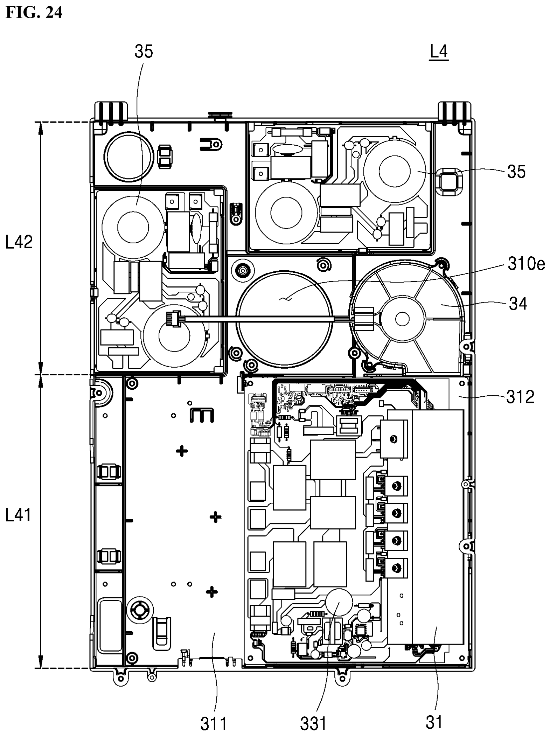

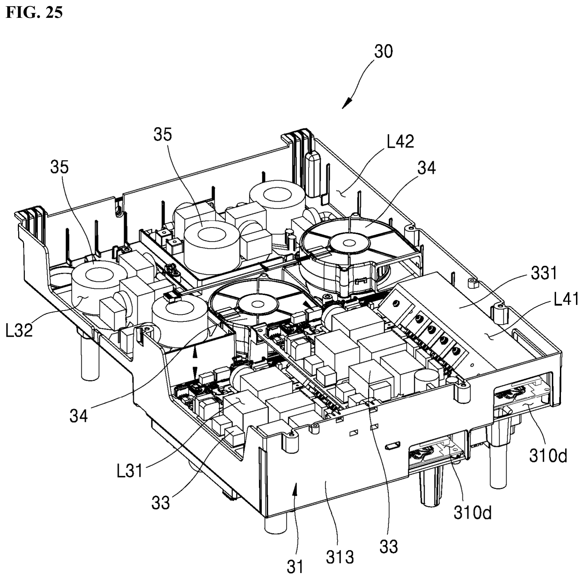

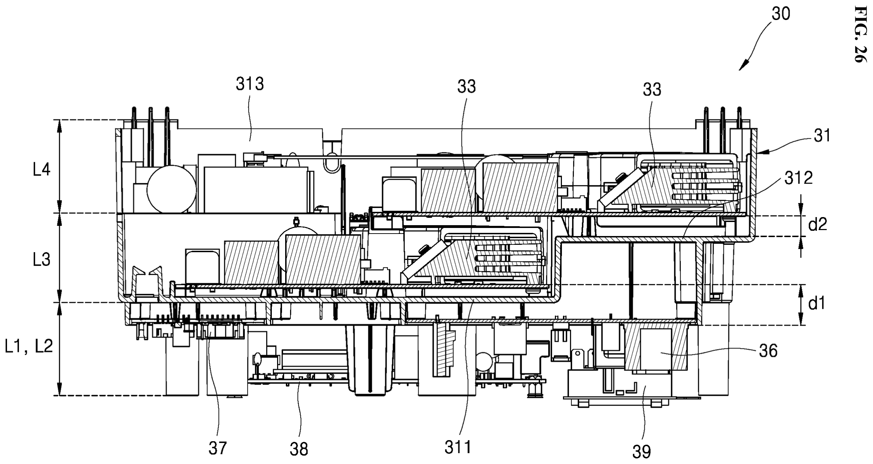

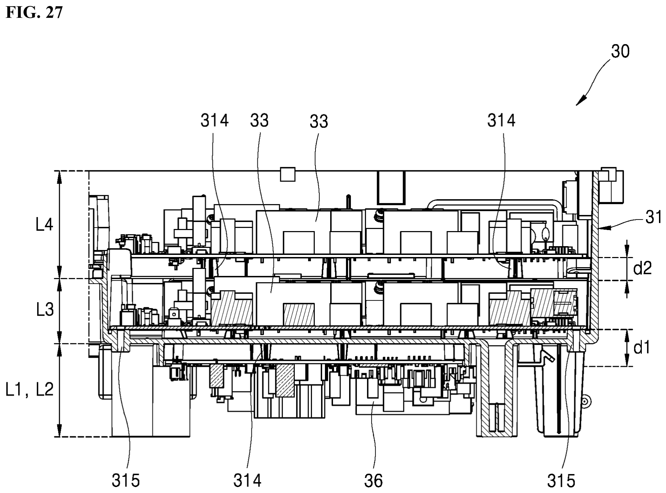

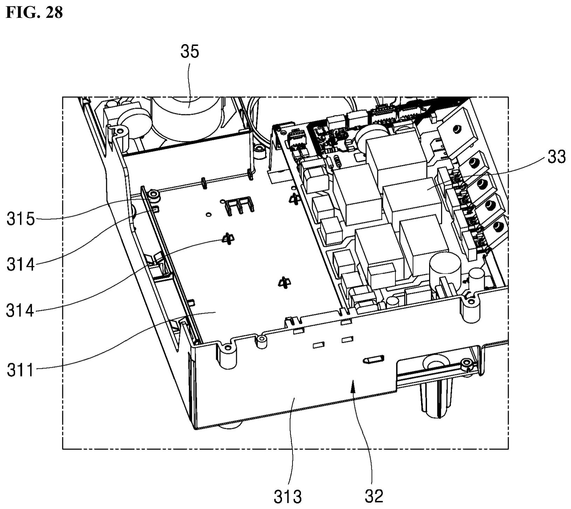

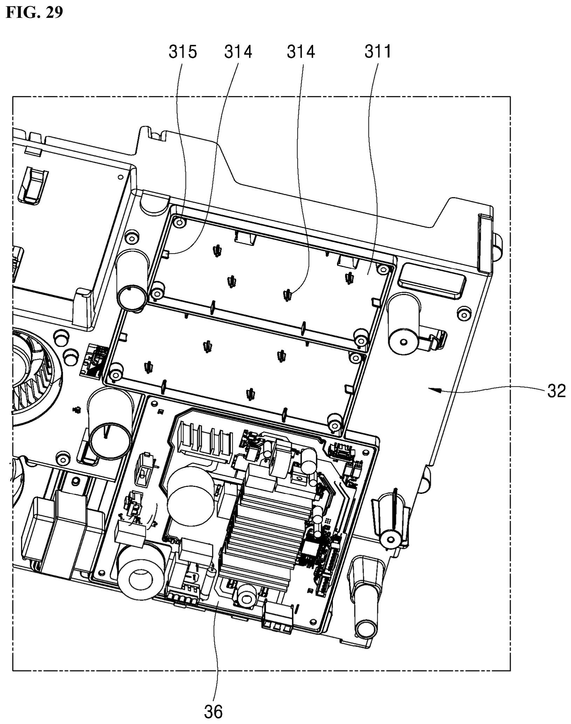

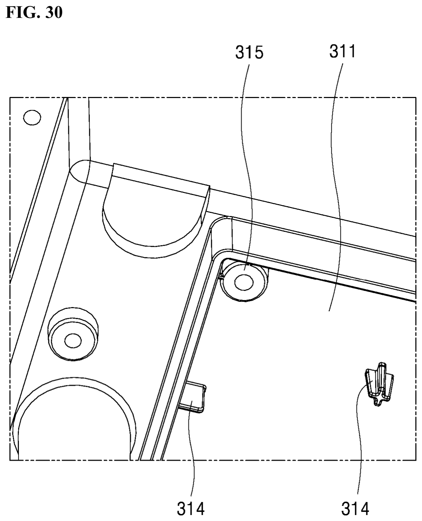

FIG. 21 is a plan cross-sectional view showing an arrangement state of the circuit parts in the first electric component space, and FIG. 22 is a bottom view showing an arrangement state of the circuit parts in the second electric component space. Further, FIG. 23 is a plan view showing an arrangement state of the circuit parts in the third electric component space, and FIG. 24 is a plan view showing an arrangement state of the circuit parts in the fourth electric component space. Further, FIG. 25 is a perspective view showing a separated structure of the first circuit part and the second circuit part on the electric component supporter, FIG. 26 is a perspective view showing an up-down separated structure of the circuit parts on the electric component supporter, and FIG. 27 is a side cross-sectional view showing the up-down separated structure of the circuit parts on the electric component supporter. Further, FIG. 28 is a view showing shapes of protruding structures formed on a bottom surface of the electric component supporter, FIG. 29 is a view showing shapes of protruding structures formed on a lower surface of the electric component supporter, and FIG. 30 is an enlarged view showing the protruding structure illustrated in FIG. 29.

According to the present embodiment, as shown in FIGS. 20 to 22, the motor driving circuit part 36, the main circuit part 37, and the power supply circuit part 38 may be disposed in the first electric component space L1 and the second electric component space L2. Specifically, the power supply circuit part 38 may be disposed in the first electric component space L1 (see FIG. 21), and the motor driving circuit part 36 may be disposed in the second electric component space L2 (see FIG. 22).

The first electric component space L1 and the second electric component space L2 are arranged in a vertical direction in a space between a lower surface of the electric component supporter 31 and a bottom surface of the electric component case 32. Among these, the first electric component space L1 is defined as a space adjacent to the bottom surface of the electric component case 32. The second electric component space L2 is defined as a space adjacent to the lower surface of the electric component supporter 31 and is disposed above the first electric component space L1.

In addition, the electric component part 30 may further include a terminal block 39. The terminal block 39 may also be disposed in the first electric component space L1 and may be installed on the bottom surface of the electric component case 32. The terminal block 39 functions as a relay point for stably connecting power lines and signal lines introduced from outside to the respective circuit parts.

The terminal block 39 may be provided in a form including an insulating housing, a plurality of metal terminals arranged therein, and a connector coupling part configured to be coupled to an external connector. A portion of the terminal block 39 (e.g., the connector coupling part) may be exposed to the outside of the electric component case 32 to be connectable to an external power source or an external control device.

According to the present embodiment, the power supply circuit part 38 receives external power through the terminal block 39. The power supply circuit part 38 may be configured in a switched mode power supply (SMPS) type to convert alternating current (AC) power into direct current (DC) power, and to distribute the converted power to the main circuit part 37 and the other circuit parts.

For example, the terminal block 39 and the power supply circuit part 38 may both be installed on a bottom surface of the electric component case 32 and disposed together in the same space, that is, the first electric component space L1. Accordingly, an entry path of the external power lines is shortened, and power supply efficiency and electrical reliability may be improved.

As the terminal block 39 and the power supply circuit part 38 are installed in the same space and on the same member, a length of a power supply line is minimized, and resistive loss of the power line and generation of electromagnetic interference are suppressed. In addition, a wiring structure is simplified, assembly efficiency is improved, and accessibility of each component during maintenance is enhanced.

The main circuit part 37 may be disposed in the second electric component space L2. Accordingly, the motor driving circuit part 36 and the main circuit part 37 may be disposed together in the second electric component space L2 and installed on a lower surface of the electric component supporter 31.

Direct current power converted by the power supply circuit part 38 is supplied to the main circuit part 37 disposed in the second electric component space L2. The main circuit part 37 is a central control circuit configured to control overall operations of the cooking appliance, and processes command signals input from the operation panel while controlling operations of the respective circuit parts based on power supplied from the power supply circuit part 38.

The terminal block 39 and the power supply circuit part 38 are disposed in the first electric component space L1, and the main circuit part 37 and the motor driving circuit part 36 are disposed in the second electric component space L2. These circuit parts are arranged in adjacent spaces according to a functional flow, thereby forming a simplified power transmission path from an external power source to the main circuit part 37 and the motor driving circuit part 36.

According to the present embodiment, the terminal block 39 and the power supply circuit part 38 are disposed in the same space. The main circuit part 37 and the motor driving circuit part 36 are disposed in a space adjacent to the space in which the terminal block 39 and the power supply circuit part 38 are disposed.

However, since the main circuit part 37, which is a control circuit part, and the motor driving circuit part 36, which is a high-power circuit part, need to be installed on the electric component supporter 31 as an insulating structure, they are disposed in the second electric component space L2. Therefore, the main circuit part 37 and the motor driving circuit part 36 are positioned above the first electric component space L1 in which the terminal block 39 and the power supply circuit part 38 are disposed.

Further, the circuit parts disposed in the first electric component space L1 and the circuit parts disposed in the second electric component space L2 are disposed in adjacent spaces, but are positioned to be spaced apart from each other in the vertical direction in order to secure an insulation distance. In addition, the circuit parts disposed in the first electric component space L1 and the circuit parts disposed in the second electric component space L2 are also disposed to be spaced apart from each other by a predetermined distance in the horizontal direction, for example, in a front-rear direction, in order to prevent mutual interference.

For example, the main circuit part 37 and the motor driving circuit part 36 disposed in the second electric component space L2 may be positioned at locations spaced upward from the terminal block 39 and the power supply circuit part 38 disposed in the first electric component space L1, and may also be positioned to be spaced apart therefrom in the front-rear direction.

With such a spaced arrangement structure in the vertical direction and the front-rear direction, an insulation distance between adjacent circuit parts is secured, and leakage or dielectric breakdown during a power supply process may be prevented. In addition, thermal and electromagnetic interference between a power circuit part and a control circuit part are minimized, thereby improving overall electrical stability and reliability of the circuit.

Referring to FIGS. 17 to 20 and FIGS. 23 to 24, the inverter circuit part 33 and the filter circuit part 35 may be respectively disposed in the third electric component space L3 and the fourth electric component space L4. More specifically, the inverter circuit part 33 may be disposed in the first divided space part L31 of the third electric component space L3 and in the first divided space part L41 of the fourth electric component space L4, and the filter circuit part 35 may be disposed in the second divided space part L32 of the third electric component space L3 and in the second divided space part L42 of the fourth electric component space L4.

Accordingly, the inverter circuit part 33 and the filter circuit part 35 may be disposed to be spaced apart from each other in the horizontal direction, for example, in the front-rear direction. Such an arrangement structure may correspond to a second separated arrangement structure.

The inverter circuit part 33 may generate relatively large heat and electromagnetic noise in a process of converting and outputting alternating current signals through high-speed switching elements. Accordingly, the inverter circuit part 33 and the filter circuit part 35 are preferably disposed to be spaced apart from each other by a predetermined distance or more so that thermal and electrical interference is minimized.

With such an arrangement structure, heat generated from the inverter circuit part 33 is suppressed from being transferred to the filter circuit part 35, and a phenomenon in which alternating current signals or noise caused by switching operations affect a circuit operation of the filter circuit part 35 may be prevented.

Accordingly, the electric component part 30 may minimize interference between a high-power circuit and a low-power circuit. Further, the electric component part 30 may maintain stable power quality through the filter circuit part 35, thereby improving operational stability of the circuit and contributing to ensuring electromagnetic compatibility of the entire cooking appliance.

According to the present embodiment, at least a portion of the inverter circuit part 33 disposed in the third electric component space L3 and at least a portion of the inverter circuit part 33 disposed in the fourth electric component space L4 may be positioned to be offset from each other in the horizontal direction. In the present embodiment, a configuration in which the inverter circuit part 33 disposed in the third electric component space L3 and the inverter circuit part 33 disposed in the fourth electric component space L4 are positioned to be offset from each other in a lateral direction is exemplified.

Further, each first circuit part 33 may include a first region and a second region. The first region is defined as a region in which a heat dissipation member 331 on which heat-generating components are installed is disposed. The second region is defined as a region in which the heat dissipation member 331 is not disposed.

In the present embodiment, the first region and the second region are arranged in the horizontal direction, and the second region of the inverter circuit part 33 disposed in the third electric component space L3 and the second region of the inverter circuit part 33 disposed in the fourth electric component space L4 are exemplarily positioned to be offset from each other in the horizontal direction. That is, the second regions of the inverter circuit parts 33 disposed in the upper and lower layers are positioned to be offset from each other in a lateral direction.

The above-described arrangement structure may also correspond to the first separated arrangement structure. With such an arrangement structure, vertical overlap between identical regions of the inverter circuit parts 33 is avoided, and thermal crosstalk and electromagnetic interference between the inverter circuit parts 33 may be suppressed.

Meanwhile, referring to FIGS. 23 to 25, the first divided space parts L31 and L41 and the second divided space parts L32 and L42 may be separated by electric components interposed therebetween, or may be separated by a height difference therebetween.

For example, the first divided space part L41 and the second divided space part L42 of the fourth electric component space L4 may be separated by the cooling fan 34, and the first divided space part L31 of the third electric component space L3 and the second divided space part L42 of the fourth electric component space L4 may also be separated by the cooling fan 34.

According to the present embodiment, the cooling fan 34 is disposed adjacent to a region in which the inverter circuit part 33 and the heat dissipation member 331 are disposed. Accordingly, the cooling fan 34 may effectively supply cooling air to the inverter circuit part 33 and the heat dissipation member 331, thereby rapidly removing heat from the heat-generating components. Thus, stability and durability of the entire inverter circuit part 33 may be improved.

As described above, in order for the cooling fan 34 to be disposed adjacent to the region in which the inverter circuit part 33 and the heat dissipation member 331 are disposed, the cooling fan 34 may be disposed between the first divided space parts L31 and L41 and the second divided space parts L32 and L42.

For example, the cooling fan 34 disposed adjacent to the inverter circuit part 33 disposed in the fourth electric component space L4 may be disposed between the inverter circuit part 33 disposed in the first divided space part L41 and the filter circuit part 35 disposed in the second divided space part L42.

Further, the cooling fan 34 disposed adjacent to the inverter circuit part 33 disposed in the third electric component space L3 may be disposed between the inverter circuit part 33 disposed in the first divided space part L31 of the third electric component space L3 and the filter circuit part 35 disposed in the second divided space part L42 of the fourth electric component space L4.

According to this arrangement, the cooling fan 34 is interposed between the inverter circuit part 33 and the filter circuit part 35, such that the inverter circuit part 33 and the filter circuit part 35 may be spaced apart from each other. That is, by interposing another electric component between the first circuit part 33 and the second circuit part, the first circuit part 33 and the second circuit part may be disposed to be separated from each other. This may correspond to an example of the third separated arrangement structure.

As described above, when the cooling fan 34 is interposed between the inverter circuit part 33 and the filter circuit part 35, an air circulation passage is formed between the two circuit parts. Accordingly, heat generated by the inverter circuit part 33 is prevented from being directly transferred to the filter circuit part 35, thereby reducing a temperature increase of the filter circuit part 35 and improving stability of the components.

In addition, since a physical separation distance and an insulation space are secured between the two circuit parts by the cooling fan 34, propagation of electrical noise generated in the inverter circuit part 33 to the filter circuit part 35 is reduced. As a result, signal processing characteristics of the filter circuit part 35 may be stably maintained, and unnecessary heat generation or malfunction of the circuit may be prevented.

The cooling fan 34 may supply cooling air in a concentrated manner toward the inverter circuit part 33, thereby allowing heat generated in the inverter circuit part 33 to be rapidly dissipated. As a result, transfer of high-temperature air toward the filter circuit part 35 is reduced, and a temperature difference between the two circuit parts may be stably maintained. Such a structure may be effective in equalizing a heat distribution of the entire electric component part 30 and preventing circuit damage or performance degradation due to high temperatures.

Meanwhile, the filter circuit part 35 disposed in the second divided space parts L32 and L42 and the inverter circuit part 33 disposed in the first divided space part L31 of the third electric component space L3 may be disposed to be spaced apart from each other in the vertical direction. For example, the filter circuit part 35 may be disposed above the inverter circuit part 33 disposed in the first divided space part L31 of the third electric component space L3. Such a structure may correspond to an example of the second separated arrangement structure in which different types of circuits are vertically separated and disposed.

With the above-described vertical separation structure, heat generated by the inverter circuit part 33 is not directly transferred to the filter circuit part 35 disposed above the inverter circuit part 33, and electrical interference may also be effectively blocked. Accordingly, the structure may contribute to preventing unstable operation of the filter circuit part 35 caused by external factors.

According to the present embodiment, the cooling fan 34 is disposed to discharge cooling air toward the inverter circuit part 33. Accordingly, the cooling air flows in a concentrated manner around the inverter circuit part 33 and the heat dissipation member 331, such that heat generated by the inverter circuit part 33 may be rapidly discharged to the outside.

On the other hand, since the filter circuit part 35 is located on a side opposite to a discharge direction of the cooling air, the filter circuit part 35 is not directly affected by the cooling air flow. Accordingly, the filter circuit part 35 is not unnecessarily overcooled, while only the thermal crosstalk with the inverter circuit part 33 is effectively blocked.

As described above, by interposing the cooling fan 34 and an insulating structure between the inverter circuit part 33 and the filter circuit part 35, and by forming a cooling air flow only toward the inverter circuit part 33, thermal crosstalk and electrical interference between the two circuit parts may be structurally blocked.

Accordingly, heat or noise generated in a high-power circuit (the inverter circuit part) is prevented from being transferred to the filter circuit part 35, thereby improving circuit stability of the filter circuit part 35. In addition, such an arrangement structure may uniformly maintain an internal temperature distribution of the electric component part 30, thereby enhancing overall operational reliability of the cooking appliance and contributing to long-term durability.

Referring to FIGS. 26 to 30, the electric component supporter 31 forms a lower structure of the electric component part 30 and includes partition parts 311 and 312 and side wall parts 313 for supporting a plurality of circuit parts. The partition parts 311 and 312 are located at different heights to partition electric component spaces arranged in the vertical direction, and upper surfaces and lower surfaces of the respective partition parts may be provided as support surfaces on which the circuit parts are installed.

According to the present embodiment, at least a portion of the partition parts 311 and 312 may form a bottom surface of the electric component supporter 31, and an opposite surface thereof, that is, a surface facing a bottom surface of the electric component case 32, may form a lower surface of the electric component supporter 31. Accordingly, both the bottom surface and the lower surface of the electric component supporter 31 may be provided as support surfaces on which the circuit parts are installed.

At least one of the bottom surface and the lower surface of the electric component supporter 31 may have a plurality of protruding structures formed thereon. In the present embodiment, protruding structures are formed on both the bottom surface and the lower surface of the electric component supporter 31. The protruding structures may include fastening bosses 315 and ribs 314, such that the circuit parts are installed with a predetermined spacing instead of being in direct contact with a surface of the electric component supporter 31.

The protruding structures formed by the fastening bosses 315 and the ribs 314 as described above serve to increase a separation distance between a plurality of circuit parts disposed in the vertical direction with the electric component supporter 31 interposed therebetween.

For example, a distance d1 between a circuit part disposed in the second electric component space L2 and a circuit part disposed in the third electric component space L3 may be set to a sum of a thickness of a bottom surface of the electric component supporter 31 or the first partition part 311 and a protrusion length of the protruding structures. Further, a distance d2 between a circuit part disposed in the third electric component space L3 and a circuit part disposed in the fourth electric component space L4 may be set to a sum of a thickness of the second partition part 312 of the electric component supporter 31 and the protrusion length of the protruding structures. That is, vertical direction separation distances between the circuit parts disposed in the respective electric component spaces may be increased by the protruding structures.

The circuit parts are physically partitioned in the vertical direction by the electric component supporter 31, and are also disposed in a spaced state by the protruding structures protruding from the bottom surface and the lower surface of the electric component supporter 31, respectively. Accordingly, an insulation distance between the circuit parts is sufficiently secured, thereby preventing insulation breakdown or leakage current, and heat transfer between heat-generating components is suppressed so that thermal crosstalk is minimized. In addition, an air flow path is formed in a space between the bottom surface or the lower surface of the electric component supporter 31 and the circuit parts, such that a flow of cooling air becomes smooth and an overall cooling performance of the electric component part 30 is improved.

Furthermore, the protruding structures may increase rigidity of the electric component supporter 31, thereby improving structural stability of the electric component supporter itself. In addition, the protruding structures may secure an air flow path between the bottom surface or the lower surface of the electric component supporter 31 and the circuit parts. The air flow path secured as described above may contribute to efficiently discharging heat generated from heat-generating components.

Among the protruding structures, each fastening boss 315 may be formed as a cylindrical structure protruding upward or downward from the bottom surface or the lower surface of the electric component supporter 31. A circuit board of each circuit part is seated on an end of the fastening boss 315 and fixed to the electric component supporter 31 by a fastening member. In this case, as a fastening length of the fastening member increases according to a protrusion height of the fastening boss 315, coupling strength and fixing stability at a coupling portion between the circuit part and the electric component supporter 31 are enhanced. Accordingly, the fastening boss 315 may effectively prevent the circuit board from being loosened or detached due to external forces such as vibration or thermal deformation.

In addition, the rib 314 may protrude from the bottom surface or the lower surface of the electric component supporter 31 at a position spaced apart from the fastening boss 315 in a horizontal direction. The rib 314 supports a portion of the circuit board from below to prevent sagging or deformation, and stably supports the circuit part. Further, the rib 314 forms a space around the rib for air flow, thereby guiding a flow of cooling air and contributing to more efficiently dissipating heat generated from heat-generating components.

As a result, the protruding structures formed on the electric component supporter 31 may simultaneously achieve multiple effects, including increasing separation distances between the circuit parts to improve insulation performance and cooling efficiency, securing rigidity of the electric component supporter, stably supporting the circuit parts, and enhancing coupling strength. Accordingly, the electric component supporter 31 may perform a key structural role in securing thermal and mechanical stability and reliability of the electric component part 30.

According to the present embodiment, the internal space of the electric component part 30 is partitioned into a plurality of electric component spaces arranged in the vertical direction, and thus a circuit accommodating capacity of the electric component part 30 may be expanded within the same horizontal width. In each of the electric component spaces inside the electric component part 30, circuit parts having different heat generation characteristics and functions may be distributedly disposed, thereby reducing mutual interference between the circuits and allowing a wiring connection structure to be formed in a more simplified manner.

Further, as the plurality of circuit parts are spaced apart and disposed in different electric component spaces as described above, thermal crosstalk and electromagnetic interference between the circuit parts is reduced, and the internal space of the electric component part 30 is clearly divided according to functions, so that a stable circuit configuration may be realized.

In addition, the plurality of inverter circuit parts 33 disposed in the internal space of the electric component part 30 are disposed in a staggered manner not only in the vertical direction but also in a lateral direction. Such a staggered arrangement structure prevents overlapping of identical circuit regions, thereby suppressing heat concentration and electromagnetic interference between the inverter circuit parts 33.

Further, a plurality of protruding structures composed of fastening bosses 315 and ribs 314 are formed on the electric component supporter 31. These protruding structures increase an up-down separation distance between the circuit parts and form air flow paths between the bottom surface or the lower surface of the electric component supporter 31 and the circuit parts, thereby improving cooling efficiency, while simultaneously reinforcing rigidity of the electric component supporter 31 to secure overall structural stability.

Ultimately, the multi-stage arrangement structure of the electric component part 30, the staggered arrangement of the inverter circuit parts 33, and the protruding structures of the electric component supporter 31 organically cooperate with one another. Through this, the electric component part 30 is maintained in a state of enhanced thermal and mechanical stability, and a highly reliable circuit configuration may be realized even within a limited internal space of the cooking appliance.

### [Separated arrangement structure of circuit parts by power type]

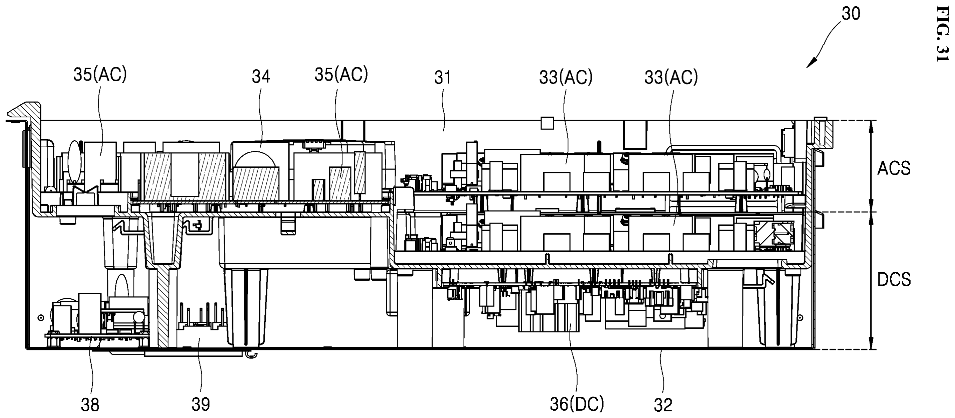

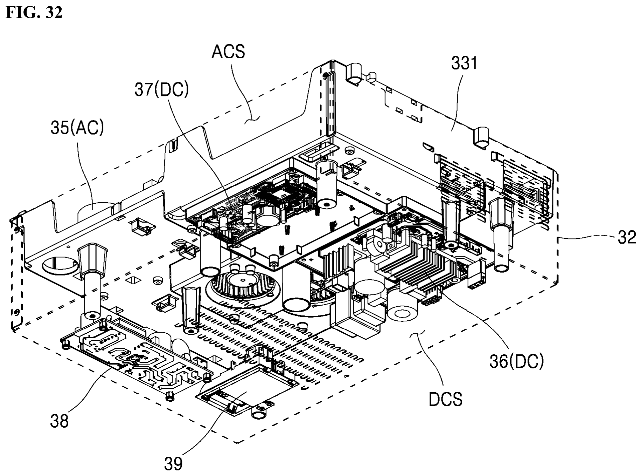

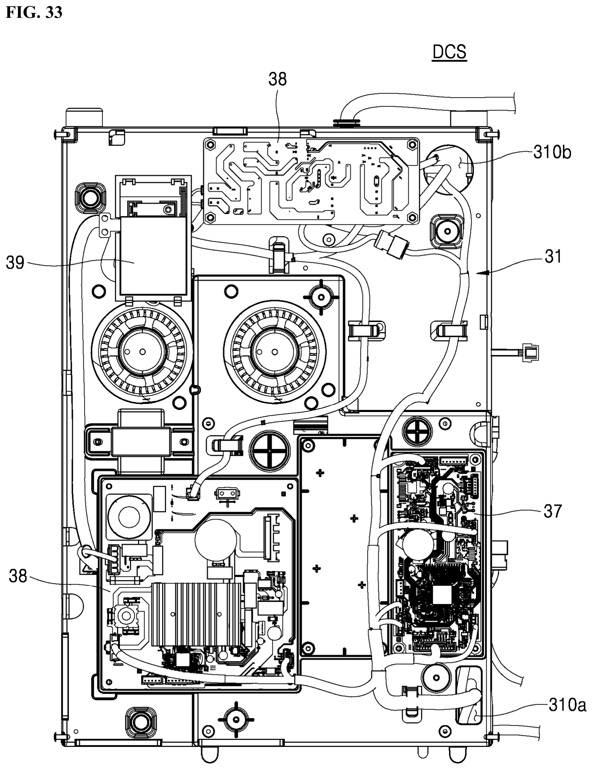

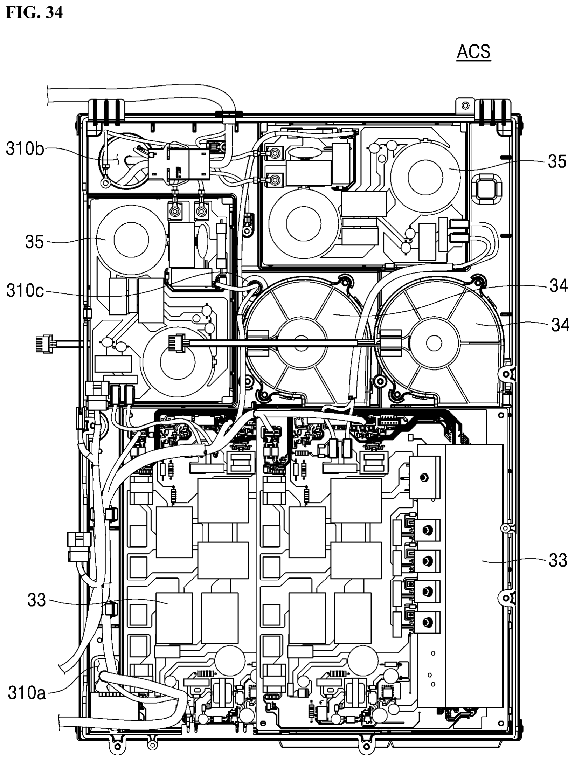

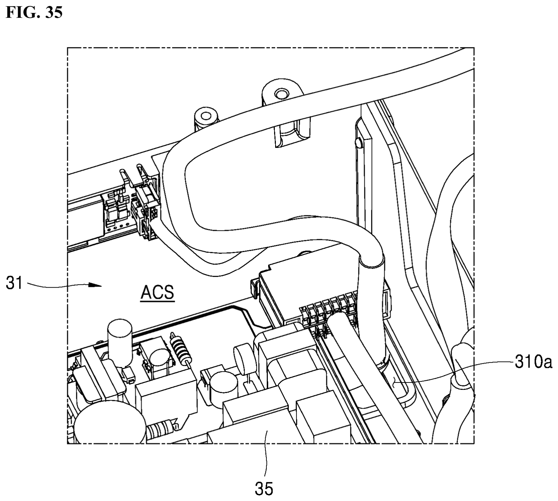

FIG. 31 is a side cross-sectional view showing an arrangement structure of a DC circuit part and an AC circuit part, and FIG. 32 is a bottom perspective view showing an arrangement state of the circuit parts in a DC-side electric component space. Further, FIG. 33 is a bottom view showing an arrangement state of circuit parts in the DC-side electric component space, FIG. 34 is a plan view showing an arrangement state of circuit parts in the AC-side electric component space, and FIG. 35 is an enlarged view showing a through hole illustrated in FIG. 34.

Referring to FIGS. 31 to 35, an internal space of the electric component part 30 may be partitioned into a DC-side electric component space DCS and an AC-side electric component space ACS by the electric component supporter 31. The partition parts 311 and 312 of the electric component supporter 31 are insulating structures extending across the two spaces, and may perform both electrical insulation and heat transfer blocking functions. Accordingly, AC circuit parts and DC circuit parts are disposed in different spaces, so that interference according to power type is structurally blocked.

According to the present embodiment, the AC-side electric component space ACS may be disposed above the DC-side electric component space DCS. For example, the DC-side electric component space DCS may be formed between the bottom surface of the electric component case 32 and the lower surface of the electric component supporter 31, and the AC-side electric component space ACS may be stepwise formed above the partition parts 311 and 312. Such a vertical separation arrangement is based on characteristics of circuits according to power type, and is advantageous in preventing switching noise and heat generated from the AC circuit parts from directly affecting the DC circuit parts.

The DC-side electric component space DCS may have DC circuit parts disposed therein. The DC circuit parts may be ones that operate by receiving DC power or output DC power among the plurality of circuit parts disposed inside the electric component part 30.

For example, the DC circuit parts may include the power supply circuit part 38, the main circuit part 37, and the motor driving circuit part 36 configured to control the fan 40. For example, the power supply circuit part 38 may be installed on the bottom surface of the electric component case 32, and the main circuit part 37 and/or the motor driving circuit part 36 may be respectively installed on the lower surface of the electric component supporter 31.

By such a distributed arrangement, power paths between the circuit parts are simplified and wiring lengths are shortened, so that voltage drops and conduction losses are reduced, and quality stability of the DC power and reliability of the system may be improved. In addition, since the DC circuit parts DC are disposed at a lower portion of the electric component part 30, thermal transfer influence from the AC circuit parts AC disposed at an upper portion of the electric component part 30 may be reduced. Accordingly, thermal stability of the DC circuit parts DC may be ensured even during long-term operation.

The AC-side electric component space ACS may have AC circuit parts AC disposed therein. The AC circuit parts AC may be ones that operate by receiving AC power or output AC power among the plurality of circuit parts disposed inside the electric component part 30. For example, the AC circuit parts AC may include the inverter circuit part 33 configured to drive a heating target disposed on the top plate 10, and the filter circuit part 35 electrically connected to the inverter circuit part 33.

The AC circuit parts AC may be installed in the AC-side electric component space ACS by using upper surfaces of the partition parts 311 and 312 of the electric component supporter 31 as support surfaces. According to such an arrangement, the filter circuit part 35 and the inverter circuit part 33 may be electrically connected in close proximity, so that a high-frequency loop length is shortened and a return path of a high-frequency current is stabilized. Accordingly, electromagnetic radiation of the AC circuit parts may be reduced, and electromagnetic compatibility and circuit efficiency of the entire system may be improved.

In addition, the electric component supporter 31 may be provided with at least one through hole 310a to 310c. For example, the through holes 310a to 310c may be formed to penetrate the partition parts 311 and 312 in the vertical direction. The through holes 310a to 310c form passages connecting the DC-side electric component space DCS and the AC-side electric component space ACS.

For example, wires connecting the terminal block 39 and the filter circuit part 35, a plurality of control signal lines connecting the main circuit part 37 with AC circuit parts including the inverter circuit part 33, and wires supplying DC power converted by the power supply circuit part 38 to the fan 34 may pass through the electric component supporter 31 through the through holes 310a to 310c. At this time, the plurality of through holes 310a to 310c may be individually formed in consideration of respective current capacities and degrees of electrical interference between circuits.

Preferably, the through holes 310a to 310c are designed to have a minimum required size, so that unnecessary air flow between the two electric component spaces is suppressed. Accordingly, a thermally separated state between the AC-side electric component space and the DC-side electric component space may be maintained, and degradation of cooling efficiency may be prevented.

According to the above-described separated arrangement structure, the AC circuit parts AC and the DC circuit parts DC are disposed in mutually separated independent spaces with the electric component supporter 31 therebetween. That is, the AC circuit parts 33 and 35 are intensively disposed in an upper space ACS of the electric component part 30, and the DC circuit parts 36, 37, and 38 are intensively disposed in a lower space DCS of the electric component part 30, so that a physical distance between circuit parts having different current characteristics is ensured.

The electric component supporter 31 is formed of a material having insulation properties and low thermal conductivity, thereby suppressing electromagnetic interference and structurally blocking a heat transfer path. Accordingly, heat generated in the AC circuit parts having a large amount of heat generation, such as the inverter circuit part 33, is suppressed from being directly transferred to the DC circuit parts, and a possibility that high-frequency currents of the AC circuit parts flow into signal lines of the DC circuit parts is minimized. As a result, electrical stability, thermal stability, and signal quality of the entire system are simultaneously improved.

In summary, the electric component part 30 according to the present embodiment implements a structure in which the AC circuit parts 33 and 35 and the DC circuit parts 36, 37, and 38 are vertically separated with respect to the partition parts 311 and 312 of the electric component supporter 31, so that circuit parts for different power types are intensively disposed in respective independent electric component spaces. Through such a structure, composite technical effects can be achieved, including: (i) reduction of electrical interference between circuit parts having different current characteristics, (ii) reduction of losses due to shortened wiring, (iii) blocking of heat transfer and improvement of cooling efficiency, (iv) improvement of electromagnetic compatibility, and (v) enhancement of system reliability and maintenance convenience.

### [Cooling structure of electric component part]

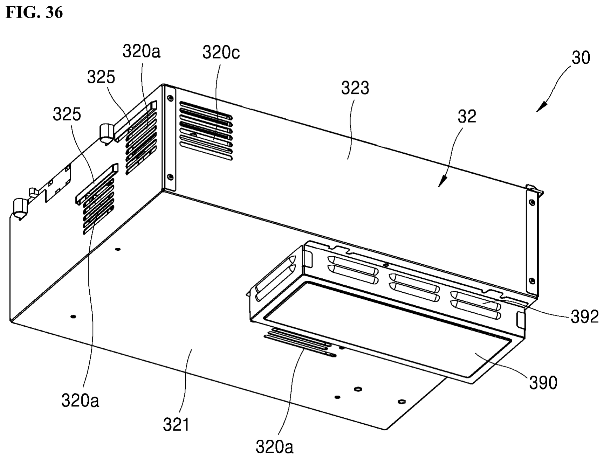

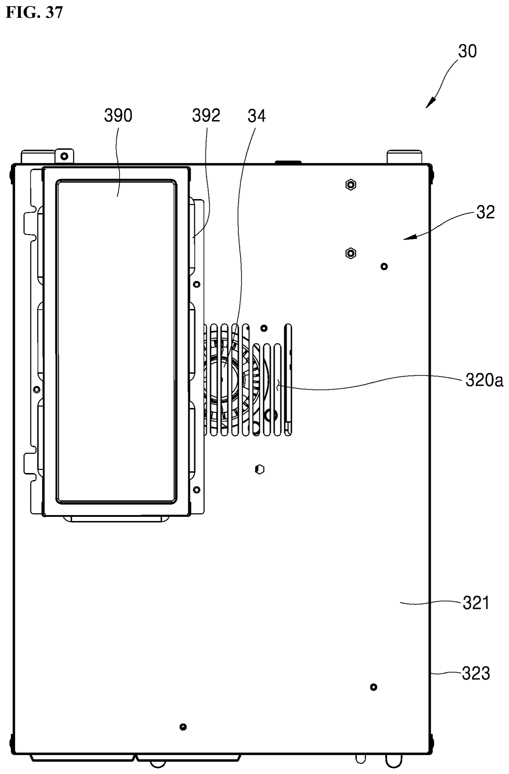

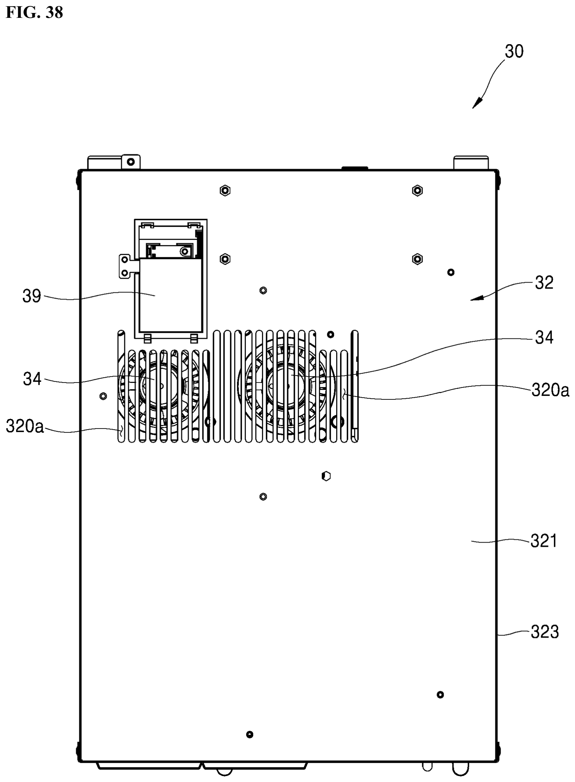

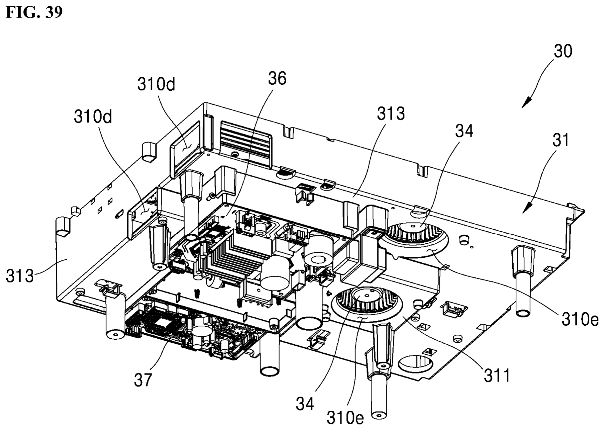

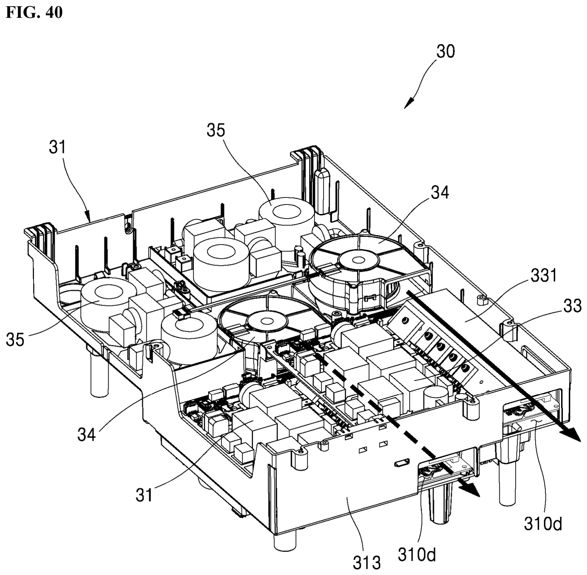

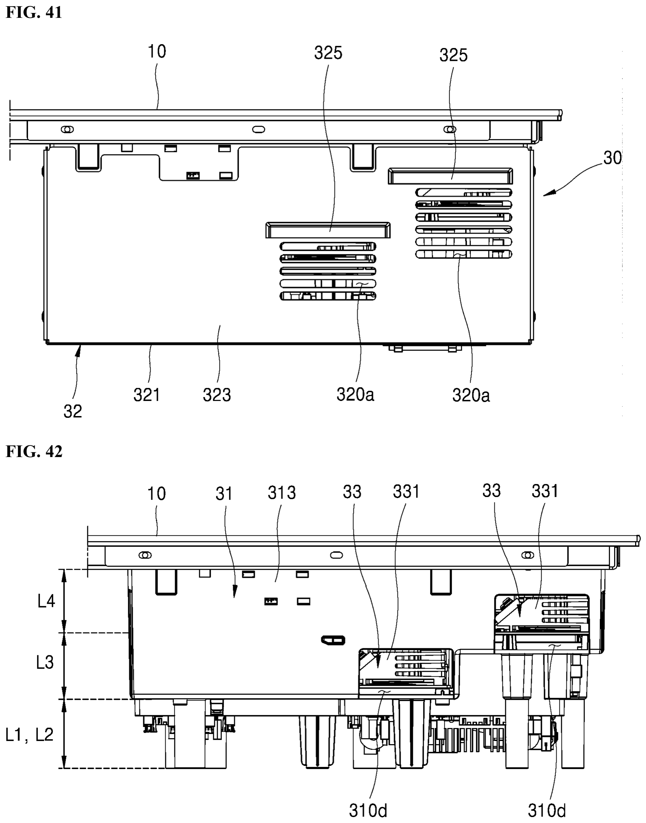

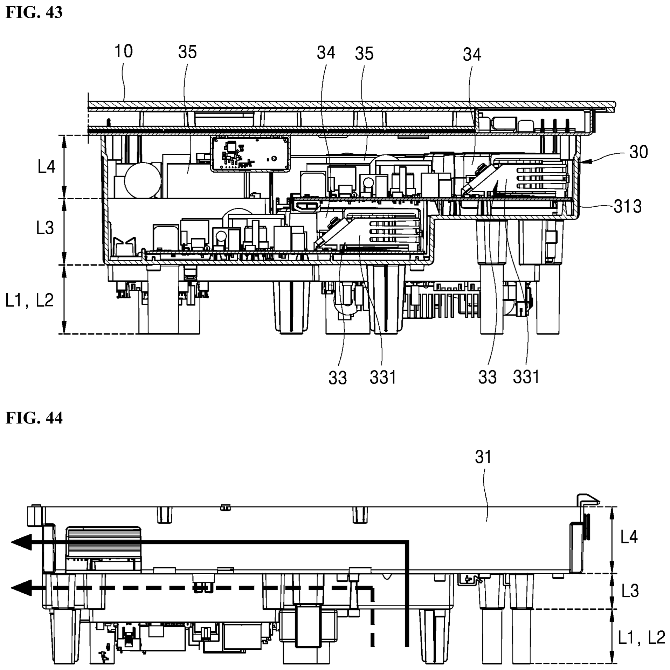

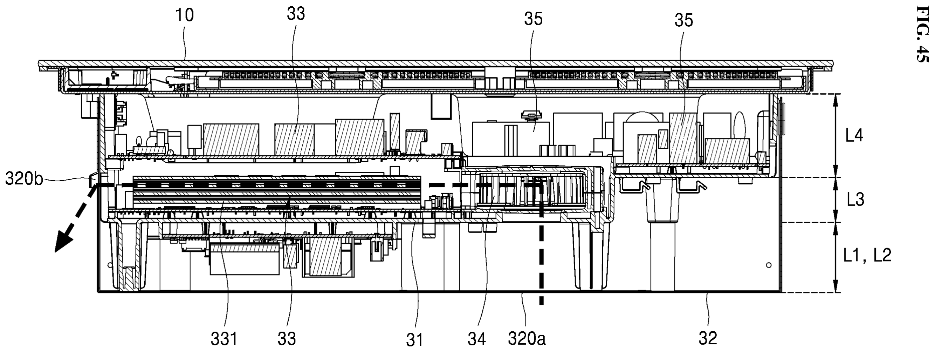

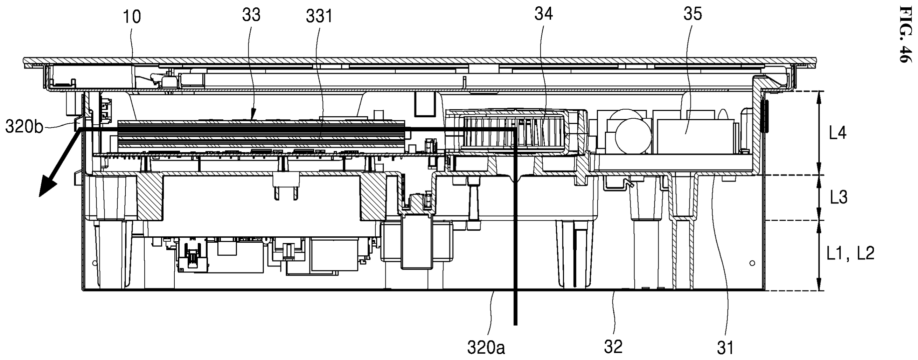

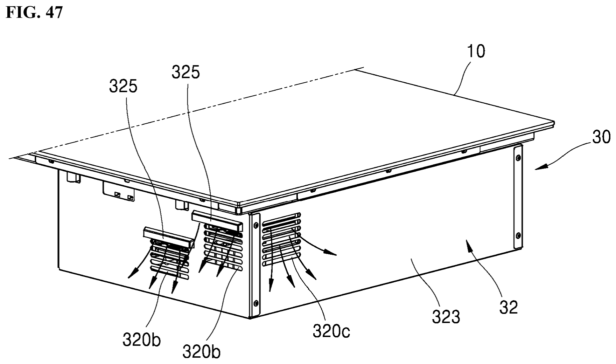

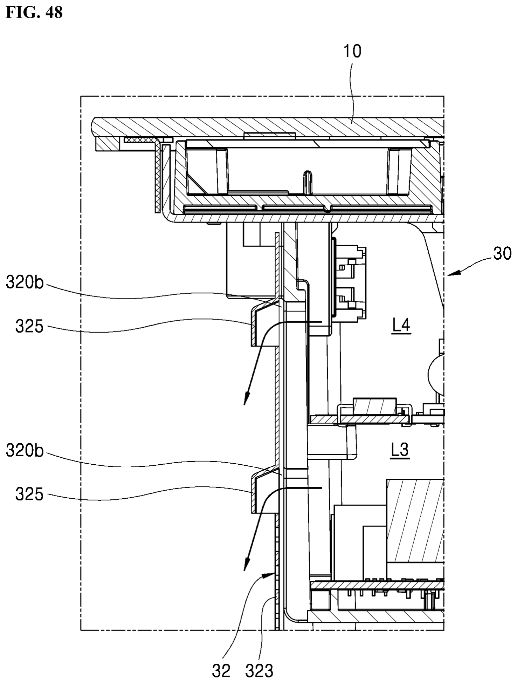

FIG. 36 is a bottom perspective view showing the electric component part according to an embodiment of the present disclosure in a disassembled state, FIG. 37 is a bottom view of the electric component part shown in FIG. 36, and FIG. 38 is a view showing a state in which a terminal cover is removed from the electric component part shown in FIG. 37. FIG. 39 is a view showing a state in which an electric component case is removed from the electric component part shown in FIG. 36, FIG. 40 is a perspective view showing a flow of cooling air in an electric component space, and FIG. 41 is a front view of the electric component part shown in FIG. 36. FIG. 42 is a view showing a state in which the electric component case is removed from the electric component part shown in FIG. 41, and FIG. 43 is a front cross-sectional view showing an internal structure of the electric component part shown in FIG. 42. FIG. 44 is a side view showing a flow of cooling air in the electric component spaces, FIG. 45 is a side cross-sectional view showing a flow of cooling air in the third electric component space, and FIG. 46 is a side cross-sectional view showing a flow of cooling air in the fourth electric component space. FIG. 47 is a view showing a cooling air exhaust flow in the electric component part, and FIG. 48 is a side cross-sectional view showing a structure of an exhaust port and a louver.

Referring to FIGS. 36 to 39, the electric component part 30 includes an intake port 320a and exhaust ports 320b and 320c. According to the present embodiment, an outer appearance of the electric component part 30 may be formed by the electric component case 32, and the intake port 320a and the exhaust ports 320b and 320c may be provided in the electric component case 32. The intake port 320a may form a passage for introducing external air into the electric component part 30, and the exhaust ports 320b and 320c may form passages for discharging air inside the electric component part 30.

The electric component case 32 may include a bottom part 321 and side wall parts 323. The bottom part 321 may form a horizontal surface facing a lower surface of the electric component supporter 31, and the side wall parts 323 may form vertical walls surrounding the bottom part 321 from a laterally outer side. The bottom part 321 may form a lower surface of the electric component case 32, and the side wall parts 323 may form a front surface, a rear surface, and both side surfaces of the electric component case 32.

The intake port 320a may be disposed in the bottom part 321, and the exhaust ports 320b and 320c may be disposed in the side wall parts 323. The intake port 320a may be formed to penetrate the bottom part 321 in a front-rear direction, and the exhaust ports 320b and 320c may be formed to penetrate the side wall parts 323 in a horizontal direction.

The electric component part 30 of the present embodiment may further include a terminal cover 390. The terminal cover 390 may cover a portion of the terminal block 39 exposed to an outside of the electric component case 32 and may be coupled to the electric component case 32.

According to the present embodiment, the terminal block 39 is installed on the bottom part 321, and a lower portion of the terminal block 39 is exposed to an outside of the bottom part 321. The terminal cover 390 may cover the lower portion of the terminal block 39 and may be coupled to the bottom part 321.

The terminal cover 390 is a protective structure for protecting the terminal block 39 from an external environment, and is coupled to the bottom part 321 of the electric component case 32. Since the terminal block 39 penetrates the bottom part 321 of the electric component case 32 and is exposed downward, the terminal block 39 may be exposed to external impact or contact with foreign substances. The terminal cover 390 surrounds and covers the exposed lower portion of the terminal block 39, thereby preventing direct contact with foreign substances or dust from the outside, or oil generated during cooking.

Some of the plurality of intake ports 320a provided in the bottom part 321 of the electric component case 32 may be covered by the terminal cover 390. In this case, the terminal cover 390 may include a separate intake port 392 on an outer surface thereof, preferably on a side surface, so that an intake function is not hindered.

The intake port 392 is formed to communicate with the intake port 320a located below the terminal cover 390, thereby providing an air passage through which external air may flow inward along a side surface of the terminal cover 390. That is, even the intake port 320a partially covered by the terminal cover 390 may be in air communication with the outside through the intake port 392, so that an air intake function through the cooling fan 34 is stably maintained.

A cooling fan 34 is disposed inside the electric component part 30 to guide external air introduced through the intake port 320a into an internal space of the electric component part 30, and to discharge the air circulated inside through the exhaust ports 320b and 320c. The cooling fan 34 is installed below the electric component supporter 31 and performs a function of transferring air upward or in a horizontal direction along the internal space of the electric component part 30. Accordingly, heat generated from the plurality of circuit parts 33, 35, 36, 37, and 38 inside the electric component part 30 is rapidly discharged to the outside, thereby suppressing an increase in an internal temperature.

Referring to FIGS. 39 to 40, the cooling fan 34 may be disposed adjacent to a first circuit part having a large heat generation amount, such as the inverter circuit part 33. Accordingly, air drawn by the cooling fan 34 efficiently absorbs heat while contacting the heat dissipation member 331, and then flows toward the exhaust ports 320b and 320c of the electric component part 30, so that cooling of the heat-generating components is intensively performed. Such a configuration not only maximizes heat dissipation performance of the inverter circuit part 33, but also shortens an overall cooling path of the electric component part 30, thereby improving cooling efficiency.

Referring to FIGS. 40 to 42, the exhaust ports 320b and 320c are formed to penetrate the side wall part 323 in a horizontal direction, and may be formed in a grille shape in order to prevent infiltration of external foreign substances. In addition, an exhaust port 310d may also be provided in the electric component supporter 31.

The exhaust port 310d may be formed to penetrate the side wall part 313 of the electric component supporter 31 in a horizontal direction, and may be disposed at a position communicating with the exhaust ports 320b and 320c. The exhaust port 310d may be disposed at a position at which the inverter circuit part disposed inside the electric component supporter 31, particularly the heat dissipation member 331, is exposed toward the exhaust ports 320b and 320c. Accordingly, air that has cooled the inverter circuit part and the heat dissipation member 331 may be smoothly discharged to the outside of the electric component part 30 through the exhaust ports 320b and 320c.

According to the present embodiment, as shown in FIG. 40 and FIGS. 43 to 46, a plurality of cooling fans 34 spaced apart from each other may be provided inside the electric component part 30. For example, one cooling fan 34 may be disposed in each of the third electric component space L3 and the fourth electric component space L4, so that mutually independent air flows are formed by the respective cooling fans 34.

Each cooling fan 34 may be installed on the partition parts 311 and 312 of the electric component supporter 31, respectively. Correspondingly, an inner intake port 310e may be provided in each of the partition parts 311 and 312. Each inner intake port 310e may form a passage that opens the cooling fan 34 to a lower side of the partition parts 311 and 312. External air introduced through the intake ports 320a provided in the bottom part 321 of the electric component case 32 may rise along the first electric component space L1 and the second electric component space L2, and then pass through the partition parts 311 and 312 through the inner intake ports 310e to be introduced into intake inlets of the cooling fans 34.

Each cooling fan 34 includes an intake inlet opened toward the inner intake port 310e, and a discharge port opened toward the exhaust ports 320b and 320c of the electric component case 32. The inner intake port 310e may be formed in a shape corresponding to an outer shape of the intake inlet of the cooling fan 34, for example, a circular shape. Accordingly, the intake inlet of the cooling fan 34 and the inner intake port 310e are matched to minimize air inflow resistance, so that air flow may be performed more smoothly.

According to the present embodiment, the intake ports 320a of the electric component case 32 may be formed in a grille shape in order to prevent infiltration of external foreign substances. Accordingly, the inner intake port 310e does not need to have such a grille structure and may be formed as a smooth circular opening. The inner intake port 310e formed as described above may expand an air inflow cross-sectional area and reduce suction loss. As a result, intake and discharge performance of the cooling fan 34 is improved, and cooling efficiency of the electric component part 30 may be more stably ensured.

Each cooling fan 34 draws external air through the intake ports 320a provided in the bottom part 321 of the electric component case 32, transfers the air upward along the electric component spaces L1 to L4 partitioned by the electric component supporter 31, and then discharges the air to the outside through the exhaust ports 320b and 320c provided in a front side or a lateral side of the electric component case 32.

For example, through the cooling fan 34 disposed in the third electric component space L3, air introduced through the intake ports 320a rises through the first electric component space L1 and the second electric component space L2 to the third electric component space L3, and is then discharged through the exhaust ports 320b and 320c on the front side or the lateral side. Meanwhile, through the cooling fan 34 disposed in the fourth electric component space L4, air introduced through the intake ports 320a passes through the first and second electric component spaces L1 and L2 and is then guided to the fourth electric component space L4 and discharged. In the first and second electric component spaces L1 and L2, the two cooling air flows may partially contact each other, but basically, independent cooling paths corresponding to the respective cooling fans 34 are formed.

At this time, as a plurality of intake ports 320a are formed in the bottom part 321 of the electric component case 32, some of the intake ports 320a may be covered by the terminal cover 390. However, the terminal cover 390 according to the present embodiment further includes an intake port 392 formed on an outer surface thereof, preferably on a lateral surface, and configured to communicate with the intake ports 320a covered by the terminal cover 390. Accordingly, even the intake ports 320a hidden by the terminal cover 390 maintain air communication with the outside, so that the intake function of the cooling fan 34 is not hindered.

Further, when a plurality of cooling fans 34 are disposed as described above, a plurality of intake ports 320a may be formed in the bottom part 321 of the electric component case 32 in correspondence with the number of the cooling fans 34. In addition, a plurality of exhaust ports 320b and 320c may also be formed in correspondence with the number of the cooling fans 34 on the front surface and/or the side surface.

For example, when two inverter circuit parts 33 are disposed in a vertical direction, two cooling fans 34 and two intake ports 320a may be disposed on the bottom part 321 in correspondence therewith, and two exhaust ports 320b and 320c may be arranged in the vertical direction. Further, the number of the cooling fans 34 may be increased or decreased according to the number of circuit parts to be cooled, and accordingly, the numbers of the intake ports 320a and the exhaust ports 320b and 320c may also be adjusted correspondingly.

In particular, the exhaust ports 320b and 320c may be disposed only on the front surface of the electric component case 32, or may be disposed on both the front surface and the side surface as needed. For example, as illustrated in FIG. 47, a pair of exhaust ports 320b may be arranged on the front surface of the electric component case 32 in the vertical direction, and a pair of exhaust ports 320c may also be arranged on the side surface of the electric component case 32 in the vertical direction. In this case, air discharged through each cooling fan can be smoothly discharged through the exhaust ports 320b on the front surface and the exhaust ports 320c on the side surface.

Referring to FIGS. 43 to 48, a plurality of exhaust ports 320b may be disposed on the front surface of the electric component part 30 so as to be spaced apart from each other in the vertical direction. Each exhaust port 320b functions as a passage for discharging air inside the electric component part 30 to the outside, and a shape of the exhaust port 320b may have, for example, a grille structure in which a plurality of slits are formed at predetermined intervals.

A louver 325 may be disposed on an upper side of each exhaust port 320b to guide a flow of air discharged by the cooling fan 34 and to control a discharge direction thereof. Each louver 325 may be disposed in correspondence with an upper side of a respective exhaust port 320b.

The louver 325 functions to guide a flow of air discharged toward a front direction of the electric component part 30 downward. The louver 325 may be formed as an integral structure by press-working or bending a metal plate of the electric component case 32, and may be formed without assembling a separate component. The number, arrangement position, shape, or forming structure of the louvers 325 may be variously changed according to design conditions or exhaust requirements of the electric component part.

According to the present embodiment, a top plate 10 is disposed above the electric component part 30, and an operation panel is disposed at a front side of the top plate 10. When air that is cooled inside the electric component part 30 and then discharged rises upward, heat may be transferred to an operation panel, thereby increasing a temperature of an operation part.

For example, the louvers 325 may be disposed on a front surface of the electric component case 32. Such louvers 325 may guide a flow of discharged air downward or forwardly downward, thereby preventing heat transfer toward the operation panel.

Each louver 325 may have a structure in which a plurality of blades are arranged with a predetermined downward inclination angle. Here, each blade is a thin plate-like member constituting the louver 325, and functions to guide a direction of discharged air downward as the air passes therethrough. An inclination angle and a spacing of the blades may be set to correspond to a discharge air volume and a flow velocity of the cooling fan 34, and accordingly, a stable exhaust direction may be secured while minimizing resistance to air flow.

Further, the louver 325 may also perform a function of preventing foreign substances or moisture from outside from flowing backward into the electric component part 30 through the exhaust port 320b. Since the blades of the louver 325 have a downward inclination, a small amount of moisture or contaminants introduced from outside may naturally flow downward along a surface of the louver and be discharged to an outside of the exhaust port. Accordingly, penetration of moisture into an interior of the electric component case 32 may be effectively prevented.

As described above, the louver 325 provided as described prevents air discharged to the outside through the exhaust port 320b from rising upward, and stably guides the discharge flow downward or forwardly downward. As a result, heat transfer to the top plate 10 and the operation panel is effectively blocked.

According to the above-described configuration, an air flow path extending from the intake port 320a to the exhaust ports 320b and 320c is shortened, thereby reducing flow resistance, and cooling efficiency of the inverter circuit part 33 and the heat dissipation member 331 may be improved.

In addition, as a plurality of cooling fans 34 are independently disposed in the electric component spaces L3 and L4, heat generated in the circuit parts disposed in the respective electric component spaces is independently cooled by the respective cooling fans 34, thereby improving overall cooling performance of the electric component part 30.

Further, since the louver 325 guides a flow of discharged air downward to block heat transfer toward the operation panel, an increase in temperature of the operation panel contacted by a user is suppressed, and safety and reliability of the product may be improved.

### [Communication module arrangement structure]

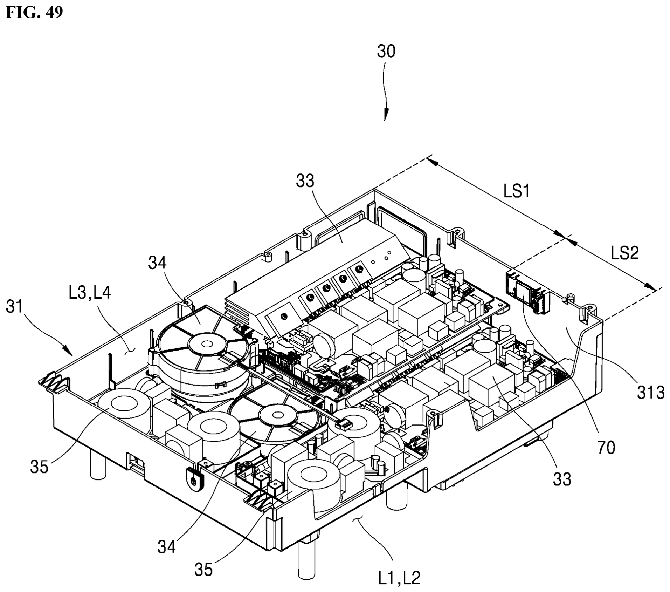

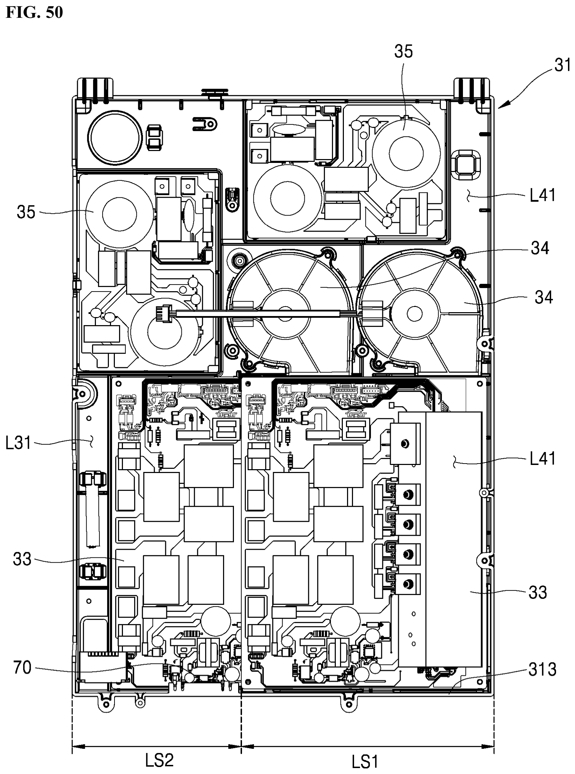

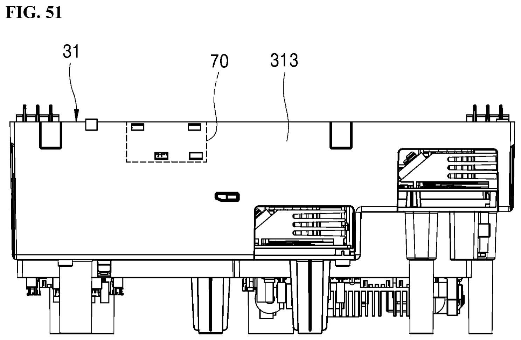

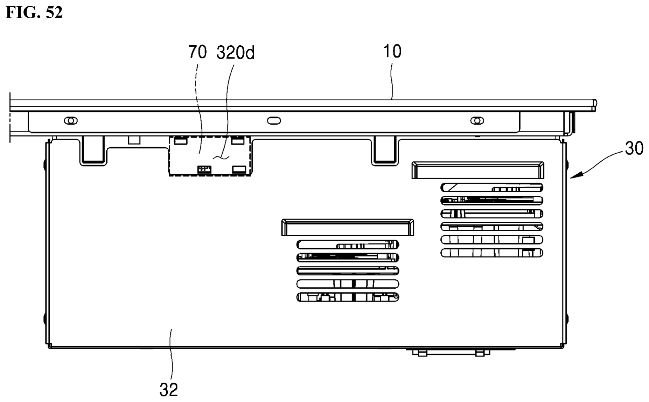

FIG. 49 is a perspective view showing an installed state of a communication module according to an embodiment of the present disclosure, and FIG. 50 is a plan view of the electric component part shown in FIG. 49. Further, FIG. 51 is a front view of the electric component part shown in FIG. 49, and FIG. 52 is a view showing a state in which an electric component case is mounted on the electric component supporter shown in FIG. 51.

The cooking appliance according to the present embodiment may include, as shown in FIGS. 49 and 50, a communication module 70 configured to perform a communication function together with the electric component part 30. The communication module 70 is a component for transmitting and receiving data between the cooking appliance and an external device, and may use, for example, a wireless communication method such as Wi-Fi, Bluetooth, or Zigbee.

According to the present embodiment, an internal space of the electric component part 30 is divided into a plurality of electric component spaces L1 to L4 in a vertical direction, and may be partitioned into a plurality of divided space part parts along a horizontal direction. Circuit parts performing different functions are disposed in the respective electric component spaces L1 to L4, and the communication module 70 may be disposed at a position spaced apart from these circuit parts.

That is, the communication module 70 may be disposed in a divided space part different from a circuit part disposed in the same electric component space among a plurality of circuit parts, or may be disposed in an electric component space different from a circuit part disposed in the same divided space part. As described above, the communication module 70 is disposed separately from the circuit parts with a boundary between electric component spaces or divided space parts therebetween. Accordingly, the communication module 70 may be protected from electromagnetic interference generated by high-power circuit parts, and degradation of wireless communication signal quality may be prevented.

An internal space of an electric component housing part may be partitioned into a plurality of lateral divided space parts LS1 and LS2 along a lateral direction (left-right direction). Each of the electric component spaces L1 to L4 is formed by being divided into a first lateral divided space part LS1 and a second lateral divided space part LS2, and the communication module 70 may be disposed in a lateral divided space part LS1 or LS2 different from that of a circuit part disposed in the same electric component space. Alternatively, the communication module 70 may be disposed in an electric component space L1 to L4 different from that of a circuit part disposed in the same lateral divided space part.

With such an arrangement, the communication module 70 is located in an independent space spaced apart from the circuit parts in at least one of a vertical direction or a left-right direction. Accordingly, influences of electrical interference, heat, noise, and the like generated inside the electric component part 30 may be effectively blocked.

Each of the electric component spaces L1 to L4 may also be divided into a first divided space part and a second divided space part arranged along a front-rear direction. The front-rear divided space parts correspond to the first divided space part and the second divided space part, and may be expressed using different terminology depending on a direction of space partitioning. The communication module 70 is disposed at a position different from that of the circuit parts in at least one of such divided space parts, thereby minimizing interference in either a front-rear direction or a lateral direction.

According to the present embodiment, the electric component supporter 31 is formed in a box shape having an open upper surface, and circuit parts may be inserted from an outside to an inside through the open upper surface of the electric component supporter 31.

As shown in FIGS. 49 to 51, the communication module 70 is installed on a side wall part 313 of the electric component supporter 31, at a position adjacent to an upper end of the side wall part 313, and a passage may be formed between the side wall part 313 and the communication module 70. This passage may be used as an insertion path in a process of inserting a circuit part, for example, the inverter circuit part 33 installed in the third electric component space L3 or the fourth electric component space L4, from an outside of the electric component supporter 31 to an inside thereof.

In the present embodiment, the inverter circuit part 33 installed in the fourth electric component space L4 is illustrated as being disposed in the first lateral divided space part LS1, and the inverter circuit part 33 installed in the third electric component space L3 is illustrated as being disposed in the second lateral divided space part LS2. In this case, the communication module 70 is disposed in the second lateral divided space part LS2, thereby being spaced apart in a lateral direction from the inverter circuit part 33 installed in the fourth electric component space L4, and being spaced apart in a vertical direction from the inverter circuit part 33 installed in the third electric component space L3.

At this time, when the communication module 70 is disposed at a position closest to the first lateral divided space part LS1 within the second lateral divided space part LS2, a distance between the communication module 70 and the side wall part 313 is increased, thereby expanding a width of the passage. Accordingly, when the inverter circuit part 33 is inserted into an inside of the electric component supporter 31 from an outside of the electric component supporter 31 through the passage in order to be installed in the third electric component space L3, insertion of the inverter circuit part 33 may be smoothly performed.

That is, the lateral arrangement of the communication module 70 is based on a structural design for sufficiently securing an assembly space for the circuit part 33, and due to such an arrangement, assemblability and productivity of the electric component part 30 are improved.

In addition, as the communication module 70 is disposed at a higher position on the electric component supporter 31, a vertical distance from the inverter circuit part 33 increases. This not only reduces electrical interference but also provides an effect of further securing an insertion passage for the inverter circuit part 33 by enlarging a lower space of the communication module 70.

According to such an arrangement, the inverter circuit part 33 may be smoothly inserted into the inside of the electric component supporter 31, and the communication module 70 is stably maintained without interference with other components during an assembly process. Accordingly, a height and position of the communication module 70 function as a structural design that improves assembly workability while simultaneously considering space utilization between components and cooling efficiency.

Referring to FIGS. 50 to 52, the electric component case 32 may be formed of a metal material, and has a function of protecting internal circuit parts and shielding electromagnetic noise. An opening part 320d may be formed in a front surface of the electric component case 32.

By means of the opening part 320d, a position of a front portion of the electric component supporter 31 corresponding to the communication module 70 in a horizontal direction may be exposed to the outside. Since the communication module 70 is exposed to the outside through the opening part 320d of the electric component case 32, influence of high-frequency noise or electromagnetic interference generated inside may be avoided.

The communication module 70 may be installed on the front surface of the electric component case 32 and disposed at a foremost position of the electric component part 30. Accordingly, the communication module 70 is positioned in a direction facing a communication counterpart disposed at a front side of the cooking appliance, for example, a user terminal or a gateway.

As a result, a distance between the communication module 70 and the communication counterpart is shortened, and a possibility that obstacles such as metal walls or internal components exist therebetween is reduced. Consequently, radio transmission and reception efficiency of the communication module 70 is improved, and wireless communication quality is enhanced. Such an arrangement structure improves communication stability of the communication module 70, and may increase communication response speed and wireless connection reliability of the cooking appliance.

In summary, the communication module 70 according to the present embodiment is disposed at a position spaced apart from at least one of a plurality of electric component spaces L1 to L4 and divided space parts within the internal space of the electric component part 30. Further, the communication module 70 is installed on a front side wall part 313 of the electric component supporter 31 and is configured to be exposed to the outside through the front opening part 320d of the electric component case 32.

With such a structure, the communication module 70 secures an installation path for the inverter circuit part 33, while improving assemblability of the electric component part 30 and preventing interference with high-power circuit parts. In addition, since the communication module 70 is installed in an open state toward a front side of the cooking appliance, radio transmission and reception efficiency is increased, and communication stability may be maximized.

### [Electric component part installation structure]

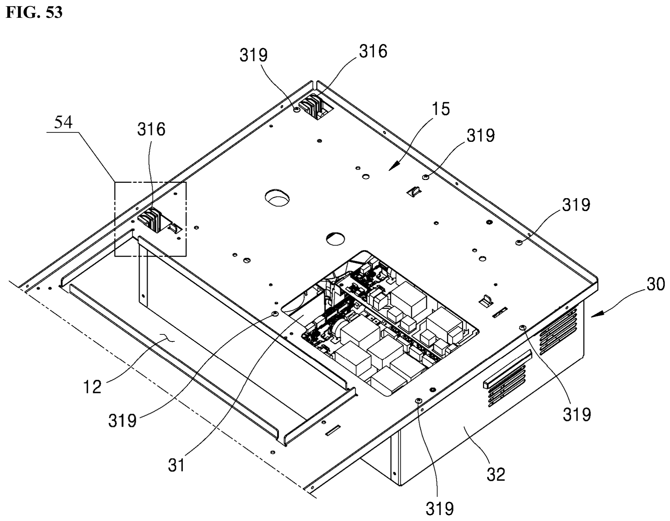

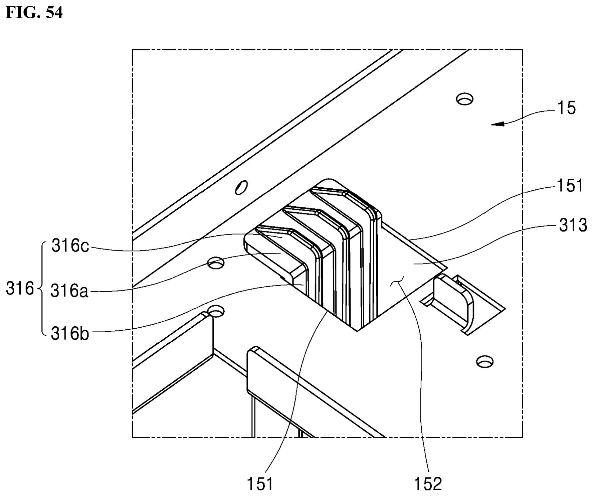

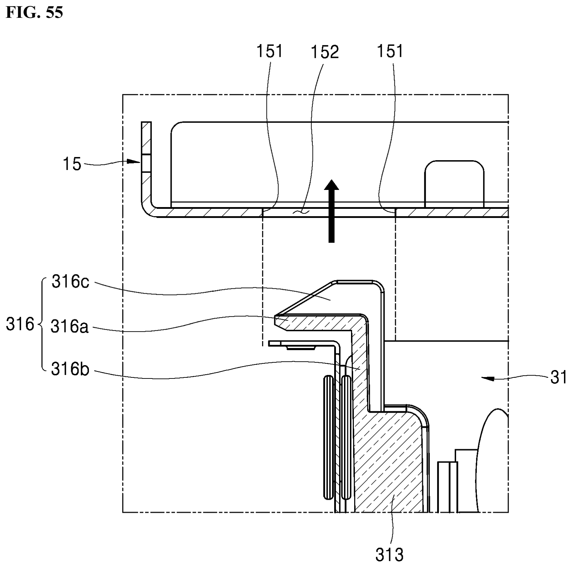

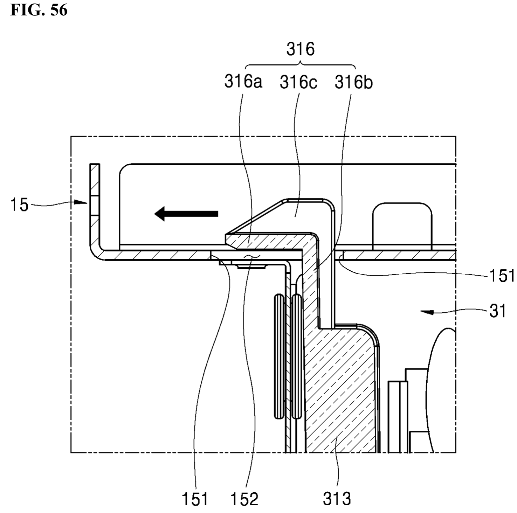

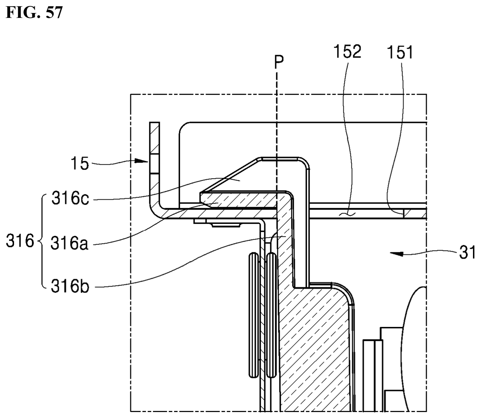

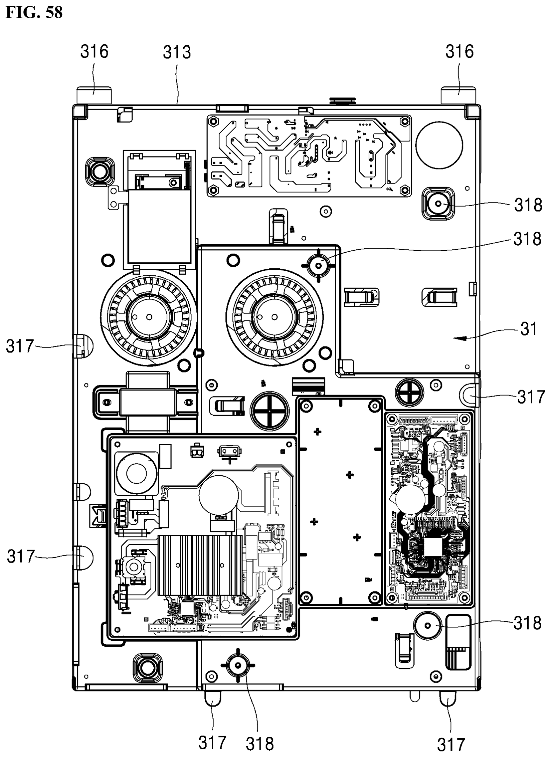

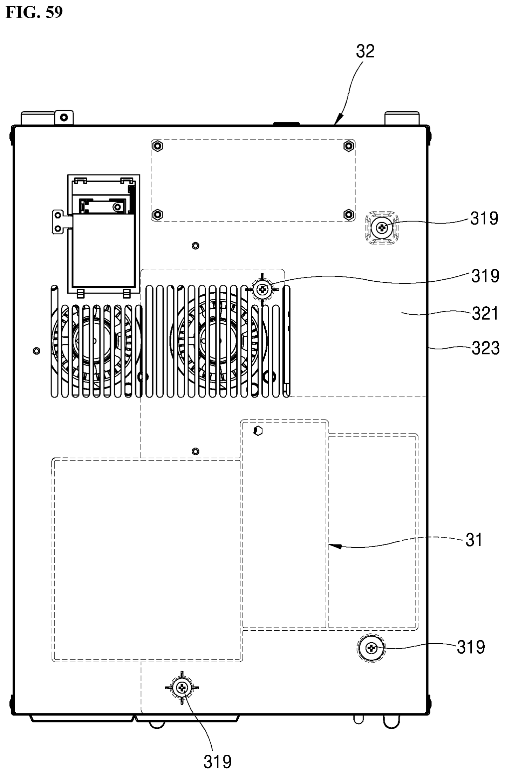

FIG. 53 is a perspective view showing a coupled state of a heating unit case and the electric component part, FIG. 54 is an enlarged view showing a portion "54" of FIG. 53, and FIGS. 55 to 56 are side cross-sectional views showing a process in which a hooking protrusion is coupled to the heating unit case. Further, FIG. 57 is a side cross-sectional view showing a state in which the hooking protrusion is coupled to the heating unit case, FIG. 58 is a bottom view illustrating a lower surface of the electric component supporter, and FIG. 59 is a view showing a state in which the electric component case is coupled to the electric component supporter shown in FIG. 58.

Referring to FIGS. 52 to 53, the electric component part 30 is disposed below the heating unit case 15 and may be coupled to the heating unit case 15. The electric component part 30 may be installed below the top plate 10 via coupling with the heating unit case 15.

According to the present embodiment, the electric component part 30 may be coupled to the heating unit case 15 via coupling between the electric component supporter 31 and the heating unit case 15. The electric component supporter 31 includes a coupling part, and the coupling part is provided to couple the electric component supporter 31 to the heating unit case 15. For example, the coupling part may include a hooking protrusion 316 and a fastening boss 317.

The hooking protrusion 316 and the fastening boss 317 may be spaced apart from each other in a horizontal direction and may be coupled to the heating unit case 15, respectively. The hooking protrusion 316 may be coupled to the heating unit case 15 to guide the position of the fastening boss 317 to a fastening position. The fastening boss 317 and the heating unit case 15 may be fastened by a fastening member 319 in a state in which the fastening boss 317 is positioned at the fastening position.

The hooking protrusion 316 may include a horizontal protrusion portion 316a and a vertical protrusion portion 316b. The horizontal protrusion portion 316a is formed to protrude in the horizontal direction from an upper end of the electric component supporter 31, and the vertical protrusion portion 316b connects the upper end of the electric component supporter 31 and the horizontal protrusion portion 316a.

The vertical protrusion portion 316b protrudes upward from an upper end of the side wall part 313 and may support a lower portion of the horizontal protrusion portion 316a. For example, the hooking protrusion 316 may be formed to protrude in an "L-shaped" configuration from the upper end of the side wall part 313.

In addition, the hooking protrusion 316 may further include a reinforcing rib portion 316c. The reinforcing rib portion 316c is formed to protrude from at least one of the horizontal protrusion portion 316a and the vertical protrusion portion 316b.

For example, the reinforcing rib portion 316c may be formed to protrude upward from the horizontal protrusion portion 316a or to protrude in a horizontal direction from the vertical protrusion portion 316b. Such a reinforcing rib portion 316c serves to increase structural rigidity of the hooking protrusion 316 and to prevent deformation due to vibration or load.

Referring to FIGS. 54 to 57, the electric component part 30 may be coupled by being inserted upward from a lower side of the heating unit case 15 and then moved rearward.

More specifically, a passage hole 152 and an inner wall 151 surrounding the passage hole 152 are formed on a bottom surface of the heating unit case 15. The inner wall 151 is disposed to surround along a laterally outer side of the passage hole 152 and substantially constitutes an inner surface of the bottom surface of the heating unit case 15 surrounding the passage hole 152. For example, with the passage hole 152 interposed therebetween, a pair of inner walls 151 are disposed to be spaced apart from each other in a front-rear direction, and another pair of inner walls 151 are disposed to be spaced apart from each other in a lateral direction, thereby forming a rectangular frame shape.

The vertical protrusion portion 316b of the hooking protrusion 316 is inserted into the passage hole 152 so as to be movable in the front-rear direction. At this time, the vertical protrusion portion 316b is formed to have a lateral length corresponding to a lateral spacing of the pair of inner walls 151 disposed to be spaced apart from each other in the lateral direction.

Accordingly, when the vertical protrusion portion 316b is inserted into the passage hole 152, left-right shaking of the hooking protrusion 316 is prevented, and movement in the front-rear direction is stably guided by the inner walls 151. In addition, by one of the pair of inner walls 151 spaced apart from each other in the front-rear direction and the vertical protrusion portion 316b coming into contact with each other in the front-rear direction, front-rear movement of the hooking protrusion 316 is restricted.

In particular, when the vertical protrusion portion 316b comes into contact in a front-rear direction with the inner wall 151 disposed on a rear side of the passage hole 152, rearward movement of the hooking protrusion 316 is stopped, and at the same time, the hooking protrusion 316 is supported above the bottom surface of the heating unit case 15 to support a rear portion of the electric component part 30. At this time, the fastening boss 317 is accurately positioned at a fastening position, and the electric component part 30 is temporarily fixed to the heating unit case 15 (see FIG. 57).

Referring to FIGS. 53 to 54, a pair of hooking protrusions 316 are disposed at the rear portion of the electric component part 30 and are respectively coupled through the passage hole 152 of the heating unit case 15. On the other hand, a plurality (for example, about five) of fastening bosses 317 are disposed at a front portion of the electric component part 30 and are coupled to the bottom surface of the heating unit case 15 via fastening members 319.

According to this configuration, the hooking protrusions 316 at the rear serve to align and support a position of the electric component part 30, and the fastening bosses 317 at the front serve to firmly fix the electric component part 30 to the heating unit case 15 via the fastening members 319.

According to the present embodiment, the hooking protrusions 316 may be formed of a synthetic resin material advantageous for securing insulation.

The inverter circuit part 33 includes heavy components such as a metal heat dissipation member 331, so that the front portion of the electric component part 30 is relatively heavier than the rear portion. However, since the synthetic resin material may have somewhat lower strength than a metal material having high strength, the hooking protrusions 316 are used for coupling the rear portion of the electric component part 30 having relatively light weight. On the other hand, the front portion of the electric component part 30 is configured to secure strong coupling force to the heating unit case 15 by using the fastening bosses 317 and the fastening members 319.

In the electric component part 30 configured as described above, the hooking protrusions 316 having relatively lower strength stably support the rear portion of the electric component part 30 to which a relatively small load is applied, and the front portion of the electric component part 30 to which a large weight is applied is firmly coupled to the heating unit case 15 through the fastening bosses 317 and the fastening members 319. Accordingly, the electric component part 30 may secure overall balanced supporting force and may form an efficient support structure according to material characteristics and load conditions of respective coupling portions.

In addition, in order to reinforce strength of the hooking protrusion 316, a reinforcing rib portion 316c may be formed on the horizontal protrusion portion 316a or the vertical protrusion portion 316b. The reinforcing rib portion 316c suppresses bending deformation or vibration displacement of the hooking protrusion 316, thereby improving durability of a rear support structure.

In addition, disposition of the hooking protrusion 316 at the rear portion of the electric component part 30 is advantageous also in terms of assembly workability. Coupling using the hooking protrusion may be easily achieved only by a simple operation of inserting the hooking protrusion into the passage hole 152, whereas fastening work using the fastening member 319 requires tool access and is relatively difficult.

Accordingly, a fastening structure using the fastening member 319 is disposed at the front portion where securing a working field of view is easy, and the hooking protrusion 316 is disposed at the rear portion where securing a working field of view is difficult. By such structural disposition, efficiency of an overall assembly process is improved, and installation work of the electric component part 30 may be performed more simply and rapidly.

Meanwhile, the electric component supporter 31 is coupled to the heating unit case 15, and the electric component case 32 has a structure coupled to the electric component supporter 31. That is, the electric component case 32 is coupled to the heating unit case 15 via the electric component supporter 31, and as a result, installation of the electric component part 30 is performed centered on the electric component supporter 31.

The electric component supporter 31 forms a positional reference of an entire electric component part through coupling with the heating unit case 15 and simultaneously may serve as a support structure for stably supporting a plurality of circuit parts. The electric component case 32 is fastened to the electric component supporter 31 to protect internal circuit parts and to perform heat dissipation and electromagnetic shielding functions.

Referring to FIG. 58, a plurality of lower fastening bosses 318 for coupling the electric component case 32 are provided at a lower surface of the electric component supporter 31. Accordingly, the electric component supporter 31 may be coupled to the heating unit case 15 at an upper portion and may be coupled to the electric component case 32 at a lower portion.

As illustrated in FIGS. 58 to 59, a bottom part 321 of the electric component case 32 is disposed below the lower surface of the electric component supporter 31 and may be coupled to the lower fastening bosses 318 below the electric component supporter 31 by fastening members 319. By this coupling, the electric component case 32 may be coupled to the electric component supporter 31.

According to the present embodiment, the electric component case 32 may be detachably coupled to the electric component supporter 31. That is, when the fastening members 319 are separated from the lower fastening bosses 318, the electric component case 32 may be separated from the electric component part 30.

In particular, since fastening portions using the fastening members 319 are disposed at a lower portion of the electric component case 32, access to the fastening members 319 is easy, and separation work of the electric component case 32 may be easily performed. When the electric component case 32 is separated in this manner, maintenance and repair of electric component parts disposed below the electric component supporter 31, that is, in a direct-current-side electric component space DCS, may be easily performed.

In such an electric component part installation structure, an inverter circuit part 33 including a metal heat dissipation member 331 is disposed at a front portion of the electric component part 30, so that weight of the front portion is greater than that of a rear portion. According to such a weight distribution, the hooking protrusions 316 made of a synthetic resin material are disposed at a rear side to support a rear portion of the electric component part 30 and secure insulation, and structural strength is supplemented through the reinforcing rib portions 316c. On the other hand, the fastening bosses 317 and the fastening members 319 are disposed at a front side to firmly fix an area in which load is concentrated.

According to the electric component part installation structure as described above, the electric component supporter 31 is temporarily fixed to the heating unit case 15 by the hooking protrusions 316 being coupled through the passage holes 152 of the heating unit case 15. At this time, the hooking protrusions 316 stably support a position of the electric component supporter 31 and simultaneously guide the fastening bosses 317 to be accurately positioned at fastening positions.

Accordingly, the electric component supporter 31 may be rapidly and accurately disposed on the heating unit case 15 without a separate jig or position adjustment process, and assembly stability of the electric component part 30 and precision of fastening work are improved. In addition, a temporary fixing structure using the hooking protrusions 316 may contribute to improving work efficiency by preventing the electric component part 30 from shaking or being detached during fastening work.

In addition, according to the present embodiment, the hooking protrusions 316 made of a synthetic resin material are disposed at the rear portion of the electric component part 30 to support the electric component part 30 in an insulated state, and structural strength is supplemented by the reinforcing rib portions 316c. On the other hand, the fastening bosses 317 and the fastening members 319 are disposed at the front portion to firmly fix an area having a large weight.

By such disposition, assembly at the rear portion is achieved by a simple operation of inserting the hooking protrusions into the passage holes 152, and fastening work at the front portion is efficiently performed due to easy tool access. Accordingly, efficiency of an overall assembly process is improved, and installation work of the electric component part 30 may be rapidly performed.

In addition, since fastening portions using the fastening members 319 are disposed at a lower portion of the electric component case 32, access to the fastening members 319 is easy, and separation work of the electric component case 32 may be easily performed. Accordingly, maintenance and repair of electric component parts disposed below the electric component supporter 31, that is, in a direct-current-side electric component space DCS, are facilitated.

As a result, the electric component part installation structure according to the present embodiment simultaneously provides temporary fixing using hooking protrusions and a fastening position guiding function and may improve structural stability, assemblability, and maintenance convenience.

The embodiments are described above with reference to a number of illustrative embodiments thereof. However, the embodiments are provided as examples, and numerous other modifications and equivalent embodiments can be drawn by one having ordinary skill in the art from the embodiments. Thus, the technical scope of protection of the subject matter of the disclosure is to be defined according to the following claims.

### [Description of Reference Numerals]

1: supporter
1a: cooking table
10: top plate
12: opening
15: heating unit case
151: inner wall
152: passage hole
20: heating unit
30: electric component part
31: electric component supporter
310a, 310b, 310c: through holes
310d: exhaust port
310e: inner intake port
311: first partition part
312: second partition part
313: side wall part
314: rib
315: fastening boss
316 : hooking protrusion
316a: horizontal protrusion portion
316b: vertical protrusion portion
316c: reinforcing rib portion
317: fastening boss
318: lower fastening boss
319: fastening member
32: electric component case
320a: intake port
320b, 320c: exhaust port
320d: opening part
321: bottom part
323: side wall part
325: louver
33: inverter circuit part
331: heat dissipation member
34: cooling fan
35: filter circuit part
36: motor driving circuit part
37: main circuit part
38: power supply circuit part
39: terminal block
390: terminal cover
392: intake port
40: fan
41: impeller
42: intake port
43: fan motor
44: exhaust port
50: first filter
55: second filter
60: hood housing
601: outer wall part
602: partition wall
603: bottom surface part
605: inner wall part
606: fan housing space
607: top surface part
61: flow path forming part
610a: discharge port
611: first filter housing part
612: connection hole
613: second filter housing part
63: fan housing part
65: fluid collecting part
650: collecting space
650a: inlet port
651: collection tray
653: connecting member
655: tray cover
67: housing cover
672: cover hole
69: fan base
AC: alternating-current circuit part
ACS: alternating-current-side electric component space
DC: circuit part
DCS: direct-current-side electric component space
L1: first housing space
L2: second housing space
L3: third housing space
L4: fourth housing space
S: component arrangement space
SS1: first space
S2: second space

## Claims

1. A cooking appliance comprising:
a top plate covering a component arrangement space; and
an electric component part disposed in the component arrangement space,
wherein the electric component part includes:
a plurality of circuit parts;
an electric component housing part accommodating the circuit parts and provided with an intake port and an exhaust port; and
a cooling fan introducing air into an internal space of the electric component housing part through the intake port and discharging the air to an outside through the exhaust port,
wherein each of the circuit parts is one of a first circuit part and a second circuit part forming different circuits,
wherein the first circuit part includes a heat dissipation member on which a heat-generating component is installed, and
wherein the heat dissipation member is disposed in an air flow path connecting the intake port and the exhaust port.

2. The cooking appliance of claim 1,
wherein the exhaust port forms a horizontal passage opening the internal space of the electric component housing part to an outside of the electric component housing part.

3. The cooking appliance of claim 2,
wherein the intake port is disposed below the cooling fan and forms a vertical passage opening the internal space of the electric component housing part to an outside of the electric component housing part, and
wherein the cooling fan is a centrifugal fan sucking air in a vertical direction and discharging the sucked air in a horizontal direction.

4. The cooking appliance of any one of preceding claims,
wherein the second circuit part includes a filter circuit part for processing power supplied to the first circuit part, and
wherein the filter circuit part is disposed at a position outside an air flow path connecting the intake port and the exhaust port.

5. The cooking appliance of claim 4,
wherein, with respect to a horizontal direction, the heat dissipation member is disposed between the cooling fan and the exhaust port, and the cooling fan is disposed between the filter circuit part and the exhaust port.

6. The cooking appliance of any one of preceding claims,
wherein the electric component housing part further includes an electric component supporter supporting at least one of the plurality of circuit parts, and
wherein the first circuit part and the cooling fan are installed on the electric component supporter.

7. The cooking appliance of claim 6,
wherein the electric component supporter includes a partition part partitioning the internal space of the electric component housing part into a plurality of electric component spaces, and
wherein the first circuit part and the cooling fan are disposed together in one of the plurality of electric component spaces.

8. The cooking appliance of claim 7,
wherein at least one of the plurality of electric component spaces includes a first divided space part and a second divided space part separated in a horizontal direction,
wherein the first divided space part has the first circuit part disposed therein,
wherein the second divided space part has the second circuit part disposed therein, and
wherein, with respect to the horizontal direction, the first divided space part is disposed between the second divided space part and the exhaust port, and the cooling fan is disposed between the first circuit part and the second circuit part.

9. The cooking appliance of claim 1,
wherein the electric component housing part further includes an electric component supporter supporting at least one of the circuit parts and the cooling fan, and an electric component case accommodating the electric component supporter, and
wherein at least one of the intake port and the exhaust port is formed in the electric component case.

10. The cooking appliance of claim 9,
wherein the electric component case includes a bottom part forming a lower surface of the electric component case, and a side wall part disposed laterally outward of the electric component supporter to form a front surface and side surfaces of the electric component case, and
wherein the exhaust port is disposed in the side wall part.

11. The cooking appliance of claim 10,
wherein the exhaust port is disposed on each of the front surface and the side surfaces of the electric component case.

12. The cooking appliance of claim 10 or 11,
wherein the electric component part further includes a louver disposed on the side wall part and blocking between the top plate and the exhaust port.

13. The cooking appliance of claim 12, further comprising:
an operation panel connected to at least one of the plurality of circuit parts, and
wherein, with respect to a vertical direction, the operation panel is disposed between the exhaust port and the top plate, and the louver is disposed between the exhaust port and the operation panel.

14. The cooking appliance of any one of preceding claims 9 to 13,
wherein the intake port is formed in a lower surface of the electric component case,
wherein the electric component part further includes a cover case covering at least a portion of the intake port and installed on the lower surface of the electric component case,
wherein an internal space of the cover case communicates with the intake port, and
wherein the cover case is formed with a side intake port opening the internal space of the cover case in a lateral direction.

15. The cooking appliance of claim 1,
wherein the electric component housing part includes an electric component supporter partitioning the internal space of the electric component housing part into a plurality of electric component spaces along a vertical direction,
wherein a plurality of cooling fans are disposed in different electric component spaces, and
wherein a plurality of exhaust ports are arranged in the vertical direction.
